# EUROPEAN PATENT APPLICATION

(11) **EP 4 525 584 A2**
(43) Date of publication of application: **19.03.2025**
(21) Application number: 24199426.8
(22) Date of filing: 10.09.2024
(51) Int. Cl.: H10D 62/10, H10D 30/01, H10D 30/43, H10D 30/00, H10D 84/01, H10D 84/85

(54) **3D-STACKED SEMICONDUCTOR DEVICE AND METHOD OF MANUFACTURING THE SAME**

(30) Priority: 14.09.2023 US 202363538401 P; 23.02.2024 US 202418586112; 31.07.2024 KR 20240102028
(71) Applicant: Samsung Electronics Co., Ltd., Suwon-si, Gyeonggi-do 16677 (KR)
(72) Inventor: YUN, Seungchan, San Jose, 95134 (US); JUNG, Myunghoon, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a semiconductor device (10U, 10L) which includes: 1^{st} source/drain regions (135) connected through a 1^{st} channel structure (110) which is controlled by a 1^{st} gate structure (115); and a 2^{nd} source/drain regions (145), respectively above the 1^{st} source/drain regions (135), connected through a 2^{nd} channel structure (120) which is controlled by a 2^{nd} gate structure (125), wherein the 1^{st} channel structure (110) and the 2^{nd} channel structure (120) comprise different materials.

## Description

### BACKGROUND

### 1. Field

Apparatuses and methods consistent with the disclosure relate to a three-dimensionally-stacked (3D-stacked) or multi-stack semiconductor device in which a channel structure, a source/drain region, and a gate structure of a transistor at a 1^{st} level are different from those of a transistor at a 2^{nd} level in dimension and material.

### 2. Description of the Related Art

A 3D-stacked semiconductor device including a transistor at a 1^{st} level and a transistor at a 2^{nd} level above the 1^{st} level has been introduced in response to increased demand for an integrated circuit having a high device density and performance. Each of the two transistors may be a fin field-effect transistor (FinFET), a nanosheet transistor or any other type of transistor. The FinFET has one or more horizontally arranged vertical fin structures as a channel structure of which at least three surfaces are surrounded by a gate structure, and the nanosheet transistor is characterized by one or more nanosheet channel layers vertically stacked on a substrate as a channel structure and a gate structure surrounding all four surfaces of each of the nanosheet channel layers. The nanosheet transistor is referred to as gate-all-around (GAA) transistor, or as a multi-bridge channel field-effect transistor (MBCFET).

In addition to 3D-stacked semiconductor device, a backside power distribution network (BSPDN) for a semiconductor device has been introduced to address a heavy traffic of signal lines and power rails at a front side of the semiconductor device. The BSPDN may contribute to reducing contact resistance between circuit elements formed at the front side of the semiconductor device. Here, the front side refers to a side where a transistor is formed with respect to a top surface of a substrate, and the back side refers to a side opposite to the front side. The BSPDN is formed on a back side of a semiconductor device, and may include backside metal lines, such as a buried power rail, and backside source/drain contact structures respectively formed on bottom surfaces of source/drain regions of a field-effect transistor such as a nanosheet transistor or a FinFET. The backside metal lines may connect the backside contact structures to a voltage source or another circuit element for signal routing.

A 3D-stacked semiconductor device with a BSPDN structure is used to form a CMOS device, such as inverter circuit, NAND gate, NOR gate, AND gate, etc., in which different polarities (p-type and n-type) of transistor are formed at the 1^{st} level and the 2^{nd} level, respectively. In this 3D-sacked semiconductor device, a work-function metal layer forming a gate structure of a transistors at the 1^{st} level may be different from that of a transistor at the 2^{nd} level when the two transistors have different polarities or of different types. The work-function metal layer of a gate structure may control a threshold voltage of a transistor formed by the gate structure. However, it is challenging to control process variations in manufacturing a 3D-stacked semiconductor device in which the gate structures for the two transistors should have different work-function metal layers in nanometer-scale dimension and also with the BSPDN structure.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides a semiconductor device including a 1^{st} transistor and a 2^{nd} transistor stacked thereon, in which the gate structures of the two transistors may be vertically isolated from each other through one or more semiconductor layers having a sufficient thickness for improved isolation between the gate structures of the two transistors.

A semiconductor device may include: 1^{st} source/drain regions connected through a 1^{st} channel structure which is controlled by a 1^{st} gate structure; and 2^{nd} source/drain regions, respectively above the 1^{st} source/drain regions, connected through a 2^{nd} channel structure which is controlled by a 2^{nd} gate structure.

As alternative or option, the 1^{st} channel structure and the 2^{nd} channel structure are formed of different materials.

As alternative or option, the 1^{st} channel structure may be formed of silicon germanium (SiGe), and the 2^{nd} channel structure may be formed of silicon (Si).

As alternative or option, length of the 1^{st} channel structure is different from a length of the 2^{nd} channel structure in a 1^{st} direction in which the 1^{st} source/drain regions are connected and the 2^{nd} source/drain regions are connected.

As alternative or option, a length of the 1^{st} gate structure is different from a length of the 2^{nd} gate structure in a 1^{st} direction in which the 1^{st} source/drain regions are connected and the 2^{nd} source/drain regions are connected.

As alternative or option, a length of the 1^{st} source/drain regions is different from a length of the 2^{nd} source/drain regions in a 1^{st} direction in which the 1^{st} source/drain regions are connected and the 2^{nd} source/drain regions are connected.

A method of manufacturing a semiconductor device may include: forming a 1^{st} channel stack at a 1^{st} level above a substrate, and forming a 2^{nd} channel stack at a 2^{nd} level above the 1^{st} level, wherein the 1^{st} and 2^{nd} channel stacks comprise different material compositions, respectively; forming a 1^{st} dummy gate structure and a 2^{nd} dummy gate structure to surround the 1^{st} channel stack and the 2^{nd} channel stack, respectively, wherein the 1^{st} and 2^{nd} dummy gate structures comprise different materials, respectively; forming 1^{st} source/drain regions at the 1^{st} level based on the 1^{st} channel stack; forming 2^{nd} source/drain regions at the 2^{nd} level based on the 2^{nd} channel stack; replacing the 2^{nd} dummy gate structure with a 2^{nd} gate structure; replacing the substrate with a backside isolation structure; and replacing the 1^{st} dummy gate structure with a 1^{st} gate structure, wherein the 1^{st} channel stack is formed by alternatingly stacking 1^{st} sacrificial layers of silicon germanium (SiGe) and 1^{st} channel layers of silicon (Si), and wherein the 2^{nd} channel stack is formed by alternatingly stacking 2^{nd} channel layers of SiGe and 2^{nd} sacrificial layers of Si.

### BRIEF DESCRIPTION OF DRAWINGS

Example embodiments of the disclosure will be more clearly understood from the following detailed description taken in conjunction with the accompanying drawings.
FIGS. 1A-1F illustrate a 3D-stacked semiconductor device 10 in which a channel structure, a source/drain region, and a gate structure of a 1^{st} transistor 10L at a 1^{st} level are different from those of a 2^{nd} transistor 10U at a 2^{nd} level in dimension and material, according to one or more embodiments.
FIGS. 2A-2E illustrate a semiconductor device structure 10' in which a 1^{st} channel stack 110', a sacrificial stack 140', and a 2^{nd} channel stack 120' are formed on a substrate 101 and surrounded by a 1^{st} dummy gate structure 115', according to one or more embodiments.
FIGS. 3A-3E illustrate the semiconductor device structure 10' in which the 1^{st} dummy gate structure 115' is partially removed to surround only the 1^{st} channel stack 110', according to one or more embodiments.
FIGS. 4A-4E illustrate the semiconductor device structure 10' in which a 2^{nd} dummy gate structure 125' is formed on the 1^{st} dummy gate structure 115' to surround the 2^{nd} channel stack 120', according to one or more embodiments.
FIGS. 5A-5E illustrate the semiconductor device structure 10' in which the 2^{nd} dummy gate structure 125' is patterned to form a 1^{st} semiconductor stack 10A, a 2^{nd} semiconductor stack 10B and a 3^{rd} semiconductor stact 10C, according to one or more embodiments.
FIGS. 6A-6E illustrate the semiconductor device structure 10' in which the 2^{nd} channel stack 120' is patterned to provide spaces for forming 2^{nd} source/drain regions therein between the 1^{st} semiconductor stack 10A, the 2^{nd} semiconductor stack 10B and the 3^{rd} semiconductor stack 10C, according to one or more embodiments.
FIGS. 7A-7E illustrate the semiconductor device structure 10' in which each of 2^{nd} sacrificial layers 121 in a 2^{nd} channel structure 120 is partially etched at side surface thereof to form a sacrificial spacer 126' on the etched side surface, according to one or more embodiments.
FIGS. 8A-8E illustrate the semiconductor device structure 10' in which the 1^{st} channel stack 110' and the substrate 101 therebelow are patterned to provide spaces for forming 1^{st} source/drain regions and placeholder structures therein between the 1^{st} to 3^{rd} semiconductor stacks 10A, 10B and 10C, according to one or more embodiments.
FIGS. 9A-9E illustrate the semiconductor device structure 10' in which each of 1^{st} sacrificial layers 11 1 in a 1^{st} channel structure 110 and 2^{nd} channel layers 122 in the 2^{nd} channel structure 120 is partially etched at a side surface thereof to form a 1^{st} inner spacer 116 on the etched side surface, and further, a placeholder structure 109' is formed in each of recesses R1 and R2 formed in the substrate 101, according to one or more embodiments.
FIGS. 10A-10E illustrate the semiconductor device structure 10' in which 1^{st} source/drain regions 135 are formed from 1^{st} channel layers 112 in the 1^{st} channel structure 110, according to one or more embodiments.
FIGS. 11A-11E illustrate the semiconductor device structure 10' in which a frontside isolation structure 141 is formed on the 1^{st} source/drain regions 135, and the sacrificial spacers 126' and the 1^{st} inner spacers 116 on the side surfaces of the 2^{nd} channel structures 120 are removed, according to one or more embodiments.
FIGS. 12A-12E illustrate the semiconductor device structure 10' in which each of the 2^{nd} sacrificial layers 121 is partially etched again at the side surface thereof to form a 2^{nd} inner spacer 126 on the etched side surface, according to one or more embodiments.
FIGS. 13A-13E illustrate the semiconductor device structure 10' in which 2^{nd} source/drain regions 145 are formed from the 2^{nd} channel layers 122, according to one or more embodiments.
FIGS. 14A-14E illustrate the semiconductor device structure 10' in which the frontside isolation structure 141 is extendedly formed on the 2^{nd} source/drain regions 145, according to one or more embodiments.
FIGS. 15A-15E illustrate the semiconductor device structure 10' in which the 2^{nd} dummy gate structure 125' and the 2^{nd} sacrificial layers 121 are removed, according to one or more embodiments.
FIGS. 16A-16E illustrate the semiconductor device structure 10' in which a 2^{nd} gate structure 125 is formed in a space provided by the removal of the 2^{nd} dummy gate structure 125' and the 2^{nd} sacrificial layers 121, according to one or more embodiments.
FIGS. 17A-17E illustrate the semiconductor device structure 10' in which a frontside contact structure 119 and a BEOL layer 160 are formed, according to one or more embodiments.
FIGS. 18A-18E illustrate the semiconductor device structure 10' in which the substrate 101 is removed therefrom, according to one or more embodiments.
FIGS. 19A-19E illustrate the semiconductor device structure 10' in which contact spacers 107 are formed on side surfaces of the placeholder structures 109' and an initial backside isolation structure 142' is formed to surround the placeholder structures 109' with the contact spacers 107 thereon, according to one or more embodiments.
FIGS. 20A-20E illustrate the semiconductor device structure 10' in which the initial backside isolation structure 142', the 1^{st} dummy gate structure 115' and the 1^{st} sacrificial layers 111 are removed, according to one or more embodiments.
FIGS. 21A-21E illustrate the semiconductor device structure 10' in which a 1^{st} gate structure 115 may be formed to surround the 1^{st} channel layers 112, according to one or more embodiments.
FIGS. 22A-22E illustrate the semiconductor device structure 10' in which the 1^{st} gate structure 115 formed in the previous step is partially etched back, and a backside isolation structure 142 may be formed at a back side of the semiconductor device structure 10', according to one or more embodiments.
FIGS. 23A-23E illustrate the semiconductor device structure 10' in which the placeholder structures 109' shown in FIGS. 22A-22E are removed therefrom, according to one or more embodiments.
FIGS. 24A-24E illustrate the semiconductor device structure 10' in which backside contact structures 109 are formed in spaces provided by the removal of the placeholder structures 109' shown in FIGS. 22A-23E, respectively, according to one or more embodiments.
FIGS. 25A-25C illustrate a flowchart of manufacturing a 3D-stacked semiconductor device in which a channel structure, a source/drain region, and a gate structure of a transistor at a 1^{st} level are different from those of a transistor at a 2^{nd} level in dimension and material in reference to FIGS. 2A-2E to 24A-24E, according to one or more embodiments.
FIG. 26 is a schematic block diagram illustrating an electronic device including the 3D-stacked semiconductor device 10 shown in FIG. 1 or the 3D-stacked semiconductor device manufactured as described above in reference to FIGS. 2A-2E to FIGS. 25A-25E, according to one or more embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}" , "2^{nd}," "3^{rd}," "4^{th}," "5^{th}," "6^{th}", etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

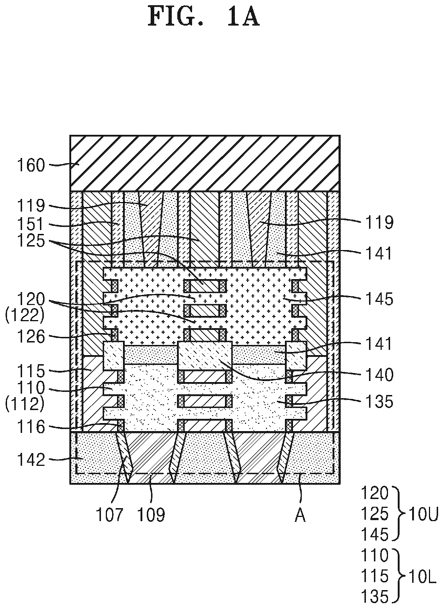

FIGS. 1A-1F illustrate a 3D-stacked semiconductor device 10 in which a channel structure, a source/drain region, and a gate structure of a 1^{st} transistor 10L at a 1^{st} level are different from those of a 2^{nd} transistor 10U at a 2^{nd} level in dimension and material, according to one or more embodiments.

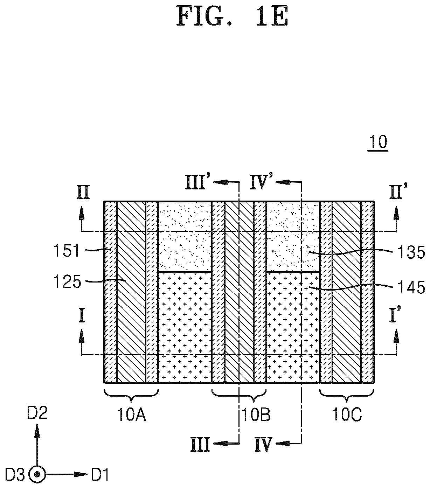

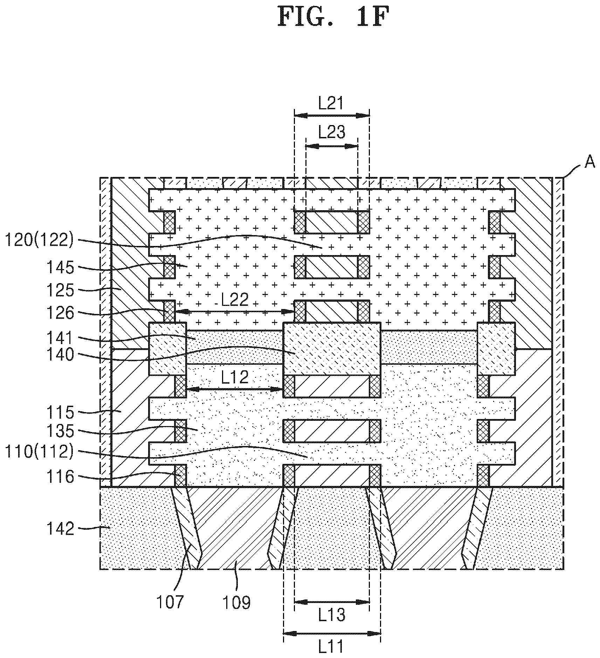

FIGS. 1A-1D are cross-section views of the 3D-stacked semiconductor device 10 shown in FIG. 1E taken along lines I-I', II-II', III-III' and IV-IV'. FIG. 1E is a plan view of the 3D-stacked semiconductor device 10. It is to be understood here that FIG. 1E is provided to show a positional relationship between channel structures, source/drain regions, and gate structures, and thus, some structural elements such as isolation layers, contact structures and a back-end-of-line (BEOL) layer shown in FIGS. 1A-1D are not shown in FIG. 1E. FIG. 1F shows an enlarged portion A indicated in FIG. 1A.

As shown in FIG. 1E, a D1 direction is a channel-length direction in which current flows between two source/drain regions connected to each other through a channel structure, a D2 direction is a channel-width direction that intersects the D1 direction, and a D3 direction is a channel-thickness direction that intersects the D1 and D2 directions.

Referring to FIGS. 1A-1F, a 3D-stacked semiconductor device 10 may include a 1^{st} semiconductor stack 10A, a 2^{nd} semiconductor stack 10B, and a 3^{rd} semiconductor stack 10C on a backside isolation structure 142.

Each of the semiconductor stacks 10A-10C may include a 1^{st} channel structure 110 surrounded by a 1^{st} gate structure 115 at a 1^{st} level and a 2^{nd} channel structure 120 surrounded by a 2^{nd} gate structure 125 at a 2^{nd} level, which may be provided above the 1^{st} level in the D3 direction. The 1^{st} channel structure 110 may include a plurality of 1^{st} channel layers 112, and the 2^{nd} channel structure 120 may include a plurality of 2^{nd} channel layers 122. These channel layers 112 and 122 may each be a thin nanosheet, nanowire or nanoribbon, and thus, a transistor formed of these channel layers may be referred to as a nanosheet transistor.

The 1^{st} channel layers 112 may connect 1^{st} source/drain regions 135 to each other to allow a current flow therebetween at a control of the 1^{st} gate structure 115. The 2^{nd} channel layers 122 may connect 2^{nd} source/drain regions 145 to each other to allow a current flow therebetween at a control of the 2^{nd} gate structure 125. Thus, the 1^{st} channel structure (including the 1^{st} channel layers 112), the 1^{st} gate structure 115 and the 1^{st} source/drain regions 135 may form a 1^{st} transistor 10L at the 1^{st} level, and the 2^{nd} channel structure 120 (including the 2^{nd} channel layers 122), the 2^{nd} gate structure 125 and the 2^{nd} source/drain regions 145 may form a 2^{nd} transistor 10U at the 2^{nd} level.

The 1^{st} channel layers 112 may each be formed of silicon (Si), and the 1^{st} source/drain regions 135 which may be epitaxially grown from the 1^{st} channel layers 112 may also be formed of silicon (Si). In contrast, the 2^{nd} channel layers 122 may each be formed of silicon germanium (SiGe), and the 2^{nd} source/drain regions 145 which may be epitaxially grown from the 2^{nd} channel layers 122 may also be formed of silicon germanium (SiGe). The 1^{st} source/drain regions 135 may be doped with n-type impurities such as phosphorus (P), arsenic (As), antimony (Sb), etc. to form the 1^{st} transistor 10L as an n-type transistor. The 2^{nd} source/drain regions 145 may be formed of SiGe doped with p-type impurities such as boron (B), gallium (Ga), indium (In), etc., to form the 2^{nd} transistor 10U as a p-type transistor.

Forming the 2^{nd} channel layers 122 with silicon germanium (SiGe), rather than silicon (Si), may enable a higher hole mobility for the current flow between the 2^{nd} source/drain regions of p-type. Thus, an improved device performance may be achieved for the 3D-stacked semiconductor device 10.

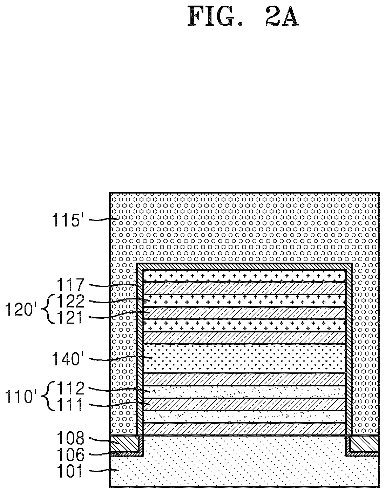

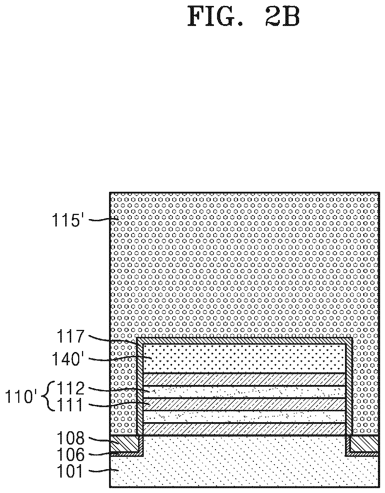

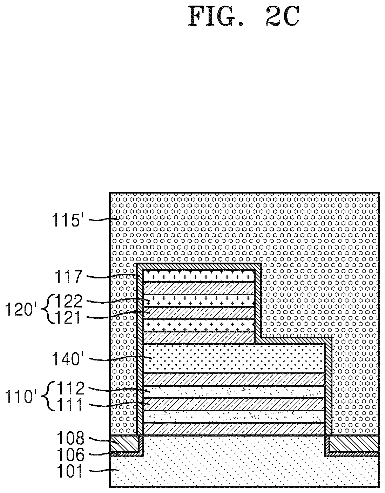

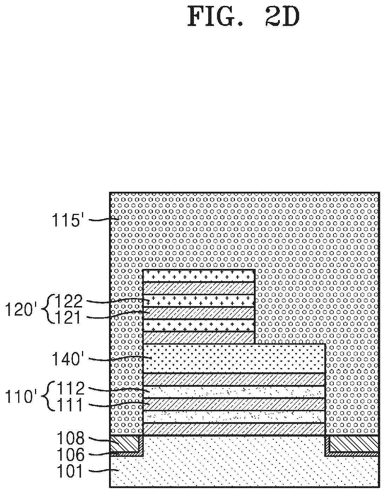

However, when the 2^{nd} channel layers 122 are formed of silicon germanium (SiGe) to function as a channel of the 2^{nd} transistor 10U while the 1^{st} channel layers 112 are formed of silicon (Si) to function as a channel of the 1^{st} transistor 10L, a 2^{nd} length L21 of the 2^{nd} channel layers 122 may be formed to be smaller than a 1^{st} length L11 of the 1^{st} channel layers 112 in the D1 direction, as shown in FIGS. 1A and 1F. Accordingly, a 4^{th} length L22 of the 2^{nd} source/drain regions 145 epitaxially grown from the 2^{nd} channel layers 122 may become greater than a 3^{rd} length L12 of the 1^{st} source/drain regions 135 epitaxially grown from the 1^{st} channel layers 112 in the same D1 direction, also as shown in FIGS. 1A and 1F. How this length difference in channel layer and source/drain region has occurred will be described later in reference to FIGS. 2A-2E to 24A-24E which illustrate a method of manufacturing the 3D-stacked semiconductor device.

In the meantime, the 1^{st} channel layers 112 and the 2^{nd} channel layers 122 included in each of the 1^{st} semiconductor stack 10A and 3^{rd} semiconductor stack 10C may be used to form the 1^{st} source/drain regions 135 and 2^{nd} source/drain regions 145 as will be described later, but may not function as respective channels for current flow for the 1^{st} transistor 10L and 2^{nd} transistor 10U in some instances. Thus, the 1^{st} semiconductor stack 10A and 3^{rd} semiconductor stack 10C may each be a dummy transistor structure, and may be removed in the 3D-stacked semiconductor device 10 in its completed form. In other instances (not shown for simplicity), the 1^{st} semiconductor stack 10A and 3^{rd} semiconductor stack 10C may be configured to be active regions of additional transistors, connecting even more source/drain regions.

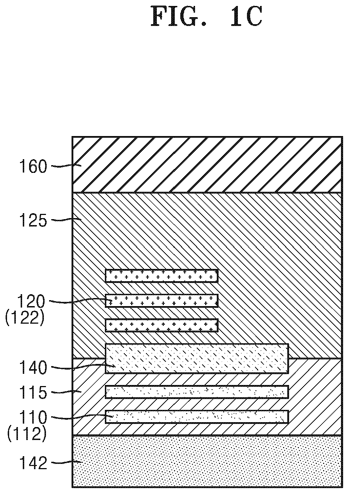

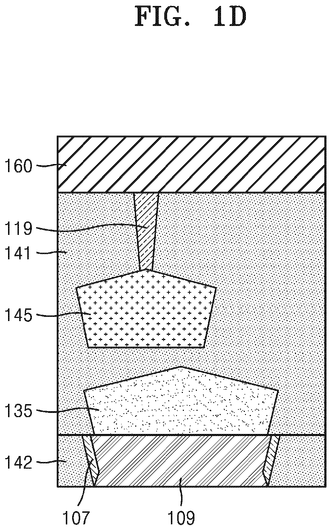

Further, as shown in FIGS. 1C and 1D, the 2^{nd} channel layers 122 may have a smaller width than the 1^{st} channel layers 112 in the D2 direction. Thus, the 2^{nd} source/drain region 145 grown from the 2^{nd} channel layers 122 may have a smaller width than the 1^{st} source/drain region 135 in the same D2 direction. Due to this width difference between the 2^{nd} source/drain region 145 and the 1^{st} source/drain region 135, a contact structure, if any, connecting the 1^{st} source/drain region 135 to a BEOL layer 160 may be formed on a top surface of the 1^{st} source/drain region 135 through a space at a right side of the 2^{nd} source/drain region 145 and above the top surface of the 1^{st} source/drain region 135 without contacting the 2^{nd} source/drain region 145 and a frontside contact structure 119 thereon. The BEOL layer 160 may include one or more metal lines that connect the 1^{st} source/drain region 135 and/or the 2^{nd} source/drain region 145 to one or more voltage sources or other circuit elements for internal routing purposes.

Instead of this frontside contact structure that may be formed on the top surface of the 1^{st} source/drain region 135, a backside contact structure 109 may be formed on a bottom surface of at least one of the 1^{st} source/drain regions 135 to avoid circuit congestion at a front side of the 3D-stacked semiconductor device 10. Thus, at least one the 1^{st} source/drain regions 135 may be connected to one or more voltage sources or other circuit elements though the backside contact structure 109. As will be described later, the backside contact structure 109 may be formed through a self-aligning process using a contact spacer 107 formed on a side surface thereof.

Still, however, the 2^{nd} source/drain regions 145 may be connected to one or more voltage sources or other circuit elements though respective frontside contact structures 119 connected to the BEOL layer 160. The backside contact structures 109 and the frontside contact structures 119 may be formed of a metal such as copper (Cu), tungsten (W), aluminum (Al), ruthenium (Ru), molybdenum (Mo), cobalt (Co), and the like, and various compounds or alloys thereof. The contact spacer 107 may be formed of silicon nitride (e.g., SiN, SiBCN, SiCN, SiOCN, etc.), not being limited thereto.

In the meantime, the 2^{nd} gate structure 125 may have a 6^{th} length L23 which is smaller than a 5^{th} length L13 of the 1^{st} gate structure 115. This gate length difference may also be caused by the material difference between the 2^{nd} channel layer 122 of silicon germanium (SiGe) and the 1^{st} channel layer 112 of silicon (Si), which may cause the length difference between the 2^{nd} channel layer 122 and the 1^{st} channel layer 112 and between the 2^{nd} source/drain region 145 and the 1^{st} source/drain region 135, as described above.

The 1^{st} gate structure 115 and the 2^{nd} gate structure 125 may each include a gate dielectric layer, a work-function metal layer, and a gate electrode. The gate dielectric layer may include an interfacial layer formed of an oxide material such as silicon oxide (SiO), silicon dioxide (SiO₂) and/or silicon oxynitride (SiON), not being limited thereto. The gate dielectric layer may further include a high-k dielectric layer formed of a high-k material such as Hf, Al, Zr, La, Mg, Ba, Ti, Pb, and/or a combination thereof, not being limited thereto.

The work-function metal layer may be formed of a metal such as titanium (Ti), tantalum (Ta), Al, W, TiN, WN, TiAl, TiAlN, TaN, TiC, TaC, TiAlC, TaCN, TaSiN, and/or a combination thereof, not being limited thereto. However, the work-function metal layers of the 1^{st} gate structure 115 and the 2^{nd} gate structure 125 having opposite polarities may be different from each other so that they may have different threshold voltages for the 1^{st} transistor 10L and the 2^{nd} transistor 10U. Thus, when the 1^{st} transistor 10L are the 2^{nd} transistor 10U are of n-type and p-type, respectively, the 1^{st} gate structure 115 of the 1^{st} transistor 10L may include a work-function metal layer formed of Al or TiC, and the 2^{nd} gate structure 125 of the 2^{nd} transistor 10U may include a work-function metal layer formed of TiN. The gate electrode may be formed of Cu, W, Al, Ru, Mo, Co, and/or a combination thereof, not being limited thereof.

As will be describe later, the 2^{nd} gate structure 125 is formed in a frontside process of manufacturing the 3D-stacked semiconductor device 10 while the 1^{st} gate structure 115 is formed in a backside process of manufacturing the 3D-stacked semiconductor device 10. Thus, process variations in forming gate structures having different work-function metal layers may have been more easily controlled in manufacturing the 3D-stacked semiconductor device 10.

The 1^{st} gate structure 115 may be isolated from the 1^{st} source/drain regions 135 through 1^{st} inner spacers 116 formed therebetween. The 2^{nd} gate structure 125 may be isolated from the 2^{nd} source/drain regions 145 through 2^{nd} inner spacers 126 formed therebetween. The gate structures 115 and 125 in each of the 1^{st} semiconductor stack 10A, the 2^{nd} semiconductor stack 10B, and a 3^{rd} semiconductor stack 10C may be protected by a gate spacer 151 which prevents the 1^{st} gate structure 115 and the 2^{nd} gate structure 125 (and dummy gate structures that are replaced by the 1^{st} gate structure 115 and the 2^{nd} gate structure 125) from being oxidized in a process of manufacturing the 3D-stacked semiconductor device 10. The 1^{st} inner spacers 116 and the 2^{nd} inner spacers 126 may be formed of silicon nitride (e.g., SiN, SiBCN, SiCN, SiOCN, etc.), not being limited thereto. The gate spacers 151 may be formed of silicon oxide or silicon nitride (e.g., SiO₂, SiN, SiBCN, SiCN, SiOC, SiOCN, etc.), not being limited thereto, which may be different from the material(s) forming the 1^{st} inner spacers 116 and the 2^{nd} inner spacers 126 at least in terms of etch selectivity.

A frontside isolation structure 141 may be formed to isolate the 1^{st} source/drain regions 135 and the 2^{nd} source/drain regions 145 from each other or from other circuit elements. On a back side of the 3D-stacked semiconductor device 10, a backside isolation structure 142 may be formed to isolate the backside contact structures 109 from each other of from another circuit element. The backside isolation structure 142 may have replaced a substrate of the 3D-stacked semiconductor device 10 during manufacturing of the 3D-stacked semiconductor device 10. The frontside isolation structure 141 and the backside isolation structure 142 may both be formed of silicon oxide (e.g., SiO or SiO₂), not being limited thereto.

A middle isolation structure 140 may be formed between the 1^{st} gate structure 115 and the 2^{nd} gate structure 125 to separate the 1^{st} gate structure 115 and the 2^{nd} gate structure 125 as shown in FIG. 1A. The middle isolation structure 140 may be formed of a dielectric material such as silicon nitride (e.g., SiBCN, SiCN, SiOCN, SiN, etc.), not being limited thereto.

In the above embodiments, the 1^{st} transistor 10L and the 2^{nd} transistor 10U have both a length difference and a width difference in channel layer, source/drain region, and a length different in gate structure. However, the disclosure is not limited thereto, the 1^{st} transistor 10L and the 2^{nd} transistor 10U may be formed to have only length differences in channel layer, source/drain region, and gate structure without the width difference, according to one or more embodiments.

In FIGS. 1A-1E, the 2^{nd} channel structure 120 of the 2^{nd} transistor 10U has three 1^{st} channel layers 122 while the 1^{st} channel structure 110 of the 1^{st} transistor 10L has two 2^{nd} channel layers 112. However, the disclosure is not limited thereto, and more or less than two 1^{st} channel layers 112 may form the 1^{st} channel structure 110, and more or less than three 2^{nd} channel layers 122 may form the 2^{nd} channel structure 120, according to embodiments. Also, in FIGS. 1A-1E, the backside contact structure 109 is formed on a bottom surface of each of the two 1^{st} source/drain regions 135. However, the disclosure is not limited thereto, and the backside contact structure 109 may be formed on a bottom surface of only one of the two 1^{st} source/drain regions 135, according to another embodiment.

Further, in the embodiments, each of the 1^{st} channel structure 110 and 2^{nd} channel structure 120 is formed of a plurality of channel layers, which are nanosheet layers, to form each of the 1^{st} transistor 10L and 2^{nd} transistor 10U as a nanosheet transistor. However, the disclosure is not limited thereto, and each of the 1^{st} channel structure 110 and 2^{nd} channel structure 120 may include a plurality of channel layers to form a nanosheet transistor or a forksheet transistor, or one or more fin structures to form a FinFET, according to one or more embodiments.

Herebelow a method of manufacturing a 3D-stacked semiconductor device 10 is provided in which a transistor at a 1^{st} level (1^{st} transistor 10L) and a transistor at a 2^{nd} level (2^{nd} transistor 10U) have different channel structures and source/drain regions in dimension and material, according to one or more embodiments.

FIGS. 2A-2E to FIGS. 15A-15E illustrate semiconductor device structures after respective steps of manufacturing a 3D-stacked semiconductor device in which a channel structure, a source/drain region, and a gate structure of a transistor at a 1^{st} level are different from those of a transistor at a 2^{nd} level in dimension and material, according to one or more embodiments.

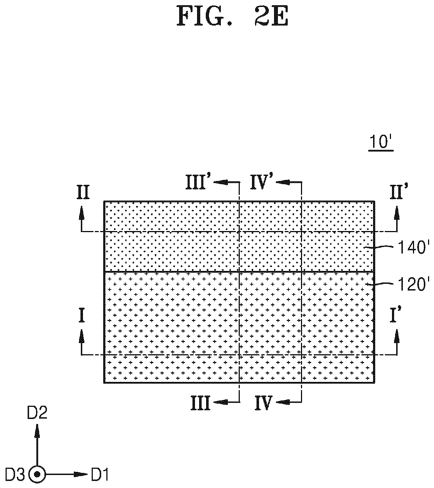

It is to be noted here that FIGS. 2A-2D to FIGS. 15A-15D are respective cross-section views of semiconductor device structures 10' shown in FIGS. 2E to 15E taken along lines I-I', II-II', III-III' and IV-IV'. FIGS. 2E to 15E are respective plan views of the semiconductor device structures 10'. However, it is to be understood here that FIGS. 2E to 15E show only positional relationships between selected structures to assist understanding of FIGS. 2A-2D to 15A-15D. Thus, structural elements formed on or above the selected structures shown in FIGS. 2A-2D to FIGS. 15A-15D may not be shown in FIGS. 2E to 15E.

As the 3D-stacked semiconductor device manufactured through the respective steps shown in FIGS. 2A-2E to FIGS. 15A-15E may be the same as or may correspond to the 3D-stacked semiconductor device 10 shown in FIGS. 1A-1E, duplicate descriptions thereof may be omitted and the same reference numbers may be used in the descriptions herebelow.

FIGS. 2A-2E illustrate a semiconductor device structure 10' in which a 1^{st} channel stack 110', a sacrificial stack 140', and a 2^{nd} channel stack 120' are formed on a substrate 101 and surrounded by a 1^{st} dummy gate structure 115', according to one or more embodiments.

Referring to FIGS. 2A-2E, the semiconductor device structure 10' may be formed by epitaxially growing a plurality of semiconductor layers one by one from the substrate 101 to form the 1^{st} channel stack 110', the sacrificial stack 140' and the 2^{nd} channel stack 120' in this order on the substrate 101. Further, the 1^{st} dummy gate structure 115' may be formed to surround the 1^{st} channel stack 110', the sacrificial stack 140' and the 2^{nd} channel stack 120' with an extra-gate (EG) layer 117 therebetween.

The substrate 101 may be a silicon (Si) substrate. Additionally or alternatively, it may include other materials such as silicon germanium (SiGe), silicon carbide (SiC), not being limited thereto. The 1^{st} channel stack 110' may include 1^{st} sacrificial layers 111 and 1^{st} channel layers 112 vertically stacked in an alternating manner on the substrate 101. In the 1^{st} channel stack 110', a 1^{st} channel layer 112 may be interposed between two adjacent 1^{st} sacrificial layers 111. On the 1^{st} channel stack 110' may be formed the sacrificial stack 140'. On the sacrificial stack 140' may be formed the 2^{nd} channel stack 120' which may include 2^{nd} sacrificial layers 121 and 2^{nd} channel layers 122 vertically stacked in an alternating manner on the sacrificial stack 140'. In the 2^{nd} channel stack 120', a 2^{nd} channel layer 122 may be interposed between two adjacent 2^{nd} sacrificial layer 121, except that an uppermost 2^{nd} channel layer 122 is interposed between an uppermost 2^{nd} sacrificial layer 121 and the extra-gate (EG) layer 117. The sacrificial stack 140' may be interposed between an uppermost 1^{st} sacrificial layer 111 and a lowermost 2^{nd} sacrificial layer 121.

In the 1^{st} channel stack 110', the 1^{st} sacrificial layers 111 may be formed of silicon germanium (SiGe), and the 1^{st} channel layers 112 may be formed of silicon (Si). In contrast, in the 2^{nd} channel stack 120', the 2^{nd} sacrificial layers 121 may be formed of Si, and the 2^{nd} channel layers 122 may be formed of SiGe. The sacrificial stack 140' may also be formed of SiGe. However, germanium (Ge) concentration in the sacrificial stack 140' may be higher than in the 1^{st} sacrificial layers 111 and the 2^{nd} channel layers 122 for etch selectivity purposes as will be described later. For example, the sacrificial stack 140' may have Ge concentration 50-60% while the 1^{st} sacrificial layers 111 and the 2^{nd} channel layers 122 may have Ge concentration 20-30%. However, the disclosure is not limited to these specific percentages as long as the sacrificial stack 140' has a higher Ge concentration than the 1^{st} sacrificial layers 111 and the 2^{nd} channel layers 122 to allow sufficient etch selectivity against the 1^{st} sacrificial layers 111 and the 2^{nd} channel layers 122.

Here, the sacrificial stack 140', the 1^{st} sacrificial layers 111, and the 2^{nd} sacrificial layers 121 are termed as such because these structural elements will be removed and replaced by other layers or structures in later steps of manufacturing the 3D-stacked semiconductor device.

After the 2^{nd} channel stack 120' is formed above the sacrificial stack 140', a portion of the 2^{nd} channel stack 120' may be etched back from top so that the 2^{nd} channel stack 120' may have a smaller width than the 1^{st} channel stack 110' in the D1 direction as shown in FIGS. 1C and 1D. This partial removal of the 2^{nd} channel stack 120' may be performed through, for example, photolithography, masking and dry etching, not being limited thereto. As will be describe later, this partial removal of the 2^{nd} channel stack 120' to have a smaller width may be performed to control a width of 1^{st} source/drain regions to be grown from the 1^{st} channel layers 112 in the 1^{st} channel stack 110' to be smaller than a width of 2^{nd} source/drain regions to be grown from the 2^{nd} channel layers 122 in the 2^{nd} channel stack 120' as described above in reference with FIGS. 1C and 1D.

The EG layer 117 may be formed to surround the 1^{st} channel stack 110', the sacrificial stack 140' and the partially-removed 2^{nd} channel stack 120' on the substrate 101 to protect the surrounded structures at least during various processes including partial removal of the 1^{st} dummy gate structure 115' in a next step. The formation of the EG layer 117 may be formed through, for example, atomic layer deposition of silicon oxide (e.g., SiO or SiO₂), not being limited thereto.

The 1^{st} dummy gate structure 115' may be formed to surround the 1^{st} channel stack 110', the sacrificial stack 140' and the partially-removed 2^{nd} channel stack 120' with the EG layer 117 therebetween. A purpose of forming the 1^{st} dummy gate structure 115' is to protect the channel stacks 110' and 120' from various processes such as deposition and etching performed to form surrounding structures in subsequent processes of manufacturing the 3D-stacked semiconductor device. The 1^{st} dummy gate structure 115' may also serve to define dimensions of the channel layers 112 and 122 for the 3D-stacked semiconductor device. The formation of the 1^{st} dummy gate structure 115' may be performed by depositing a material such as silicon nitride (e.g., SiN, SiBCN, SiCN, SiOCN, etc.) through, for example, physical vapor deposition (PVD), chemical vapor deposition (CVD), plasma enhanced chemical vapor deposition (PECVD), or a combination thereof, followed by planarization such as chemical-mechanical polishing (CMP), not being limited thereto.

Prior to the epitaxial growth of the channel stacks 110' and 120', the substrate 101 may be patterned to form a shallow trench isolation (STI) structure 108 at upper-left and upper-right corners thereof with an STI liner 106 therebetween to isolate the semiconductor device structure 10' or the 3D-stacked semiconductor device to be manufactured from the semiconductor device structure 10' from one or more adjacent semiconductor devices or circuit element. The STI structure 108 may include silicon oxide (e.g., SiO or SiO₂), not being limited thereto, and the STI liner 106 may include silicon nitride (e.g., SiN or Si₃N₄), not being limited thereto.

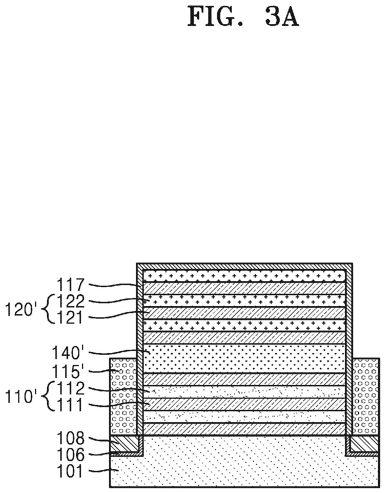

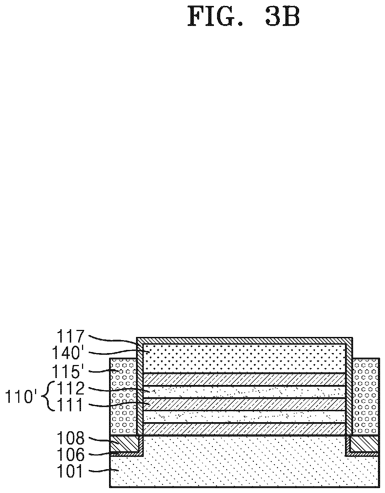

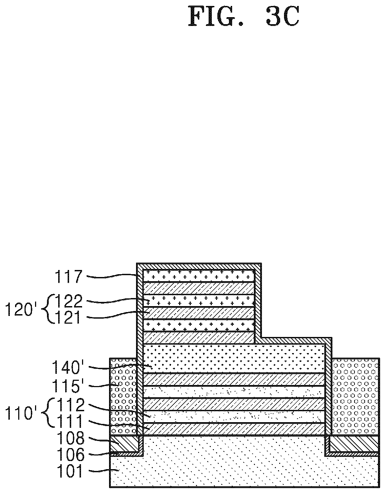

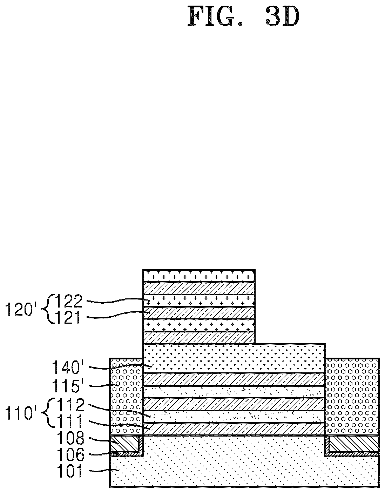

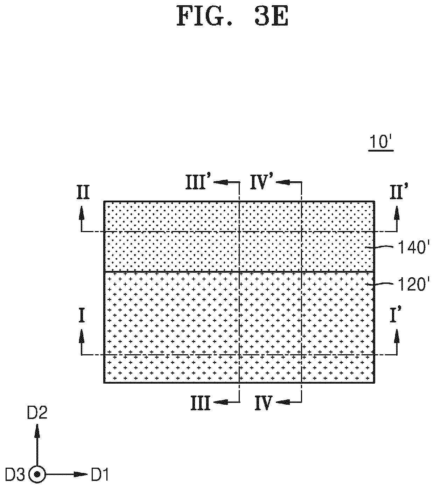

FIGS. 3A-3E illustrate the semiconductor device structure 10' in which the 1^{st} dummy gate structure 115' is partially removed to surround only the 1^{st} channel stack 110', according to one or more embodiments.

Referring to FIGS. 3A-3E, the 1^{st} dummy gate structure 115' may be partially etched back so that a top surface thereof is placed at a level between a top surface and a bottom surface of the sacrificial stack 140'. This partial etching operation may be performed on the semiconductor device structure 10' to expose a portion of the EG layer 117 surrounding the 2^{nd} channel stack 120' and an upper portion of the sacrificial stack 140' while the 1^{st} channel stack 110' and a lower portion of the sacrificial stack 140' are laterally surrounded by the 1^{st} dummy gate structure 115'.

The partial removal of the 1^{st} dummy gate structure 115' in this step may be performed through, for example, dry etching, not being limited thereto.

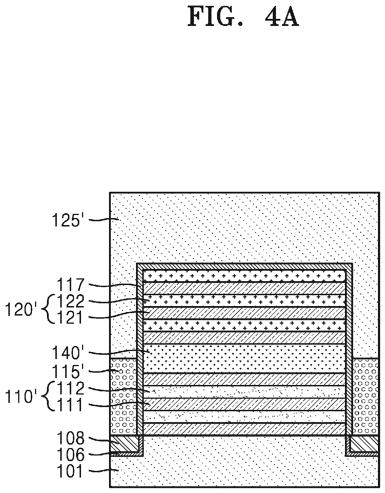

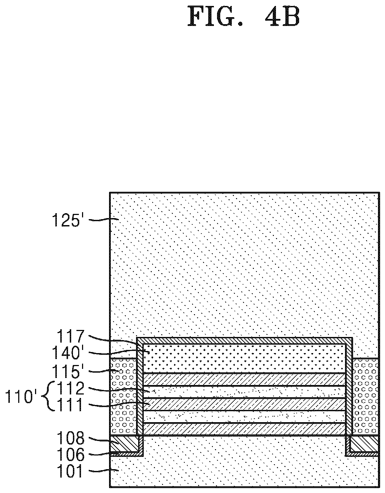

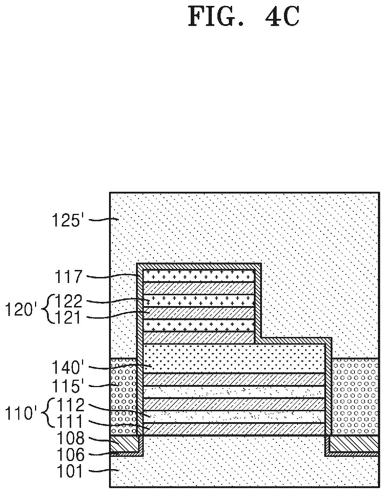

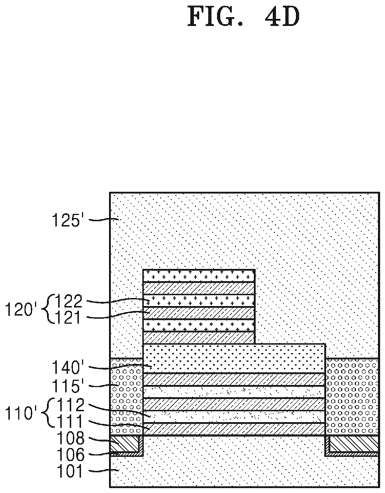

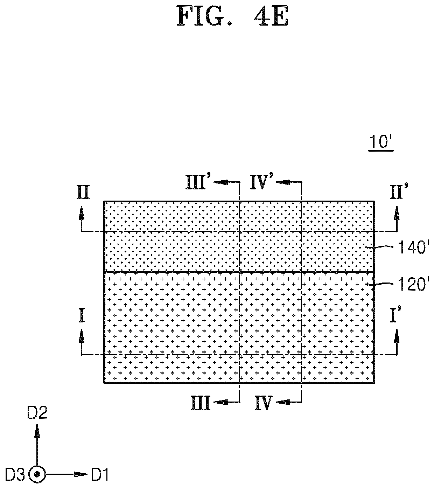

FIGS. 4A-4E illustrate the semiconductor device structure 10' in which a 2^{nd} dummy gate structure 125' is formed on the 1^{st} dummy gate structure 115' to surround the 2^{nd} channel stack 120', according to one or more embodiments.

Referring to FIGS. 4A-4E, the 2^{nd} dummy gate structure 125' may be formed to surround the 2^{nd} channel stack 120' and the upper portion of the sacrificial stack 140' with the EG layer 117 thereon which are exposed by the partial etching of the 1^{st} dummy gate structure 115' in the previous step.

The formation of the 2^{nd} dummy gate structure 125' may be performed by depositing a material such as amorphous silicon (a-Si) or polycrystalline silicon (p-Si) through, for example, PVD, CVD, PECVD, or a combination thereof, followed by planarization such as CMP, not being limited thereto.

As will be described later, the 1^{st} and 2^{nd} dummy gate structures 115' and 125' may be formed to surround the 1^{st} and 2^{nd} channel stacks 110' and 120', respectively, at least to form respective gate structures to replace the two dummy gate structures at different steps, that is, a frontside process and a backside process.

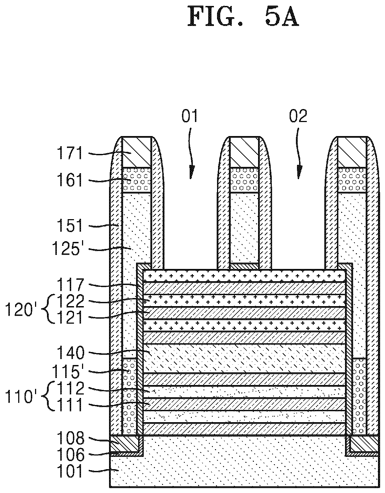

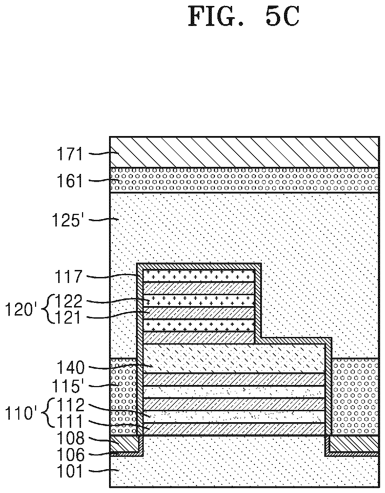

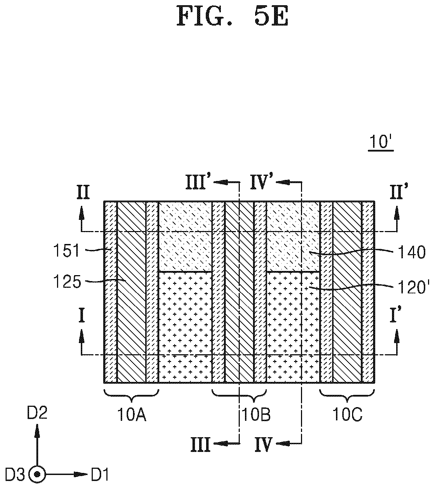

FIGS. 5A-5E illustrate the semiconductor device structure 10' in which the 2^{nd} dummy gate structure 125' is patterned to form a semiconductor stack 10A, a 2^{nd} semiconductor stack 10B and a 3^{rd} semiconductor stack 10C, according to one or more embodiments.

Referring to FIGS. 5A-5E, the 2^{nd} dummy gate structure 125' with the EG layer 117 thereon may be patterned through, for example, directional dry etching such as reactive ion etching (RIE) based on hard mask patterns 161 and mask protection patterns 171 respectively formed thereon as masking structure. By this etching operation, the 2^{nd} dummy gate structure 125' may be divided into three 2^{nd} dummy gate structures 125' with a 1^{st} opening O1 and a 2^{nd} opening O2 therebetween. Thus, the uppermost 2^{nd} channel layer 122 of the 2^{nd} channel stack 120' may be exposed through the 1^{st} opening O1 and the 2^{nd} opening O2.

Further, the sacrificial stack 140' may be removed through, for example, selective etching such as dry etching or wet etching using hydrofluoric acid (HF), which etches the sacrificial stack 140' formed of silicon germanium (SiGe) with a high germanium (Ge) concentration of 50-60% against the 1^{st} sacrificial layers 111 formed of SiGe with a low Ge concentration of 20-30% and the 1^{st} channel layers 112 formed of silicon (Si), the 2^{nd} sacrificial layers 121 also formed of silicon (Si), and the 2^{nd} channel layers 122 formed of SiGe with a low Ge concentration of 20-30%. Subsequently, in a space provided by the removal of the sacrificial stack 140' may be filled in with a dielectric material such as silicon nitride (e.g., SiBCN, SiCN, SiOCN, SiN, etc.), not being limited thereto, to form a middle isolation structure 140.

In addition, a gate spacer 151 may be formed on side surfaces of each of the divided 2^{nd} dummy gate structures 125' by depositing silicon oxide or silicon nitride (e.g., SiO₂, SiN, SiBCN, SiCN, SiOC, SiOCN, etc.) through, for example, ALD, plasma-enhanced ALD (PEALD), PVD, CVD, PECVD, or a combination thereof, followed by dry etching, not being limited thereto. The gate spacer 151 may be formed to isolate or protect the 1^{st} dummy gate structure 115' and the 2^{nd} dummy gate structure 125' (and 1^{st} gate structure and 2^{nd} gate structure which will replace the 1^{st} dummy gate structures 115' and the 2^{nd} dummy gate structure 125' in later steps) from being oxidized in subsequent processes of manufacturing the 3D-stacked semiconductor device.

The hard mask patterns 161 may include a dielectric material such as silicon nitride (SiN), titanium nitride (TiN), or silicon oxynitride (SiON), not being limited thereto. The mask protection patterns 171 may be formed of silicon oxide (e.g., SiO or SiO₂), not being limited thereto. The mask protection patterns 162 may protect the hard mask patterns 161 when the gate spacers 151 are formed on side surfaces of the 1^{st} dummy gate structures 115' and the 2^{nd} dummy gate structure 125'.

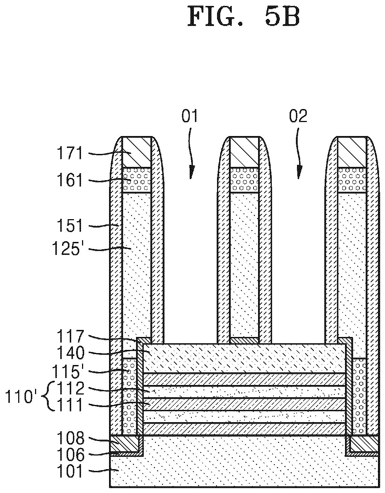

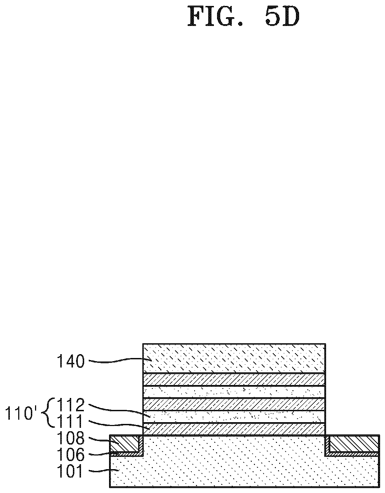

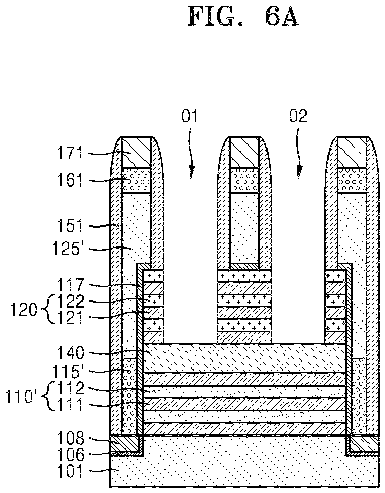

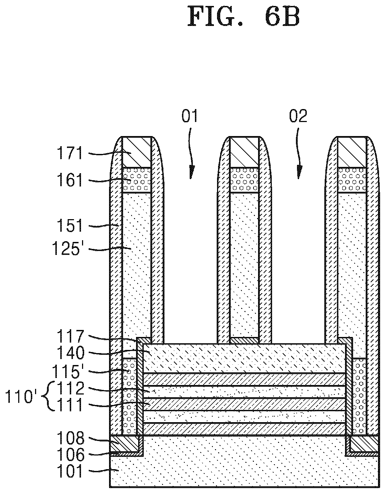

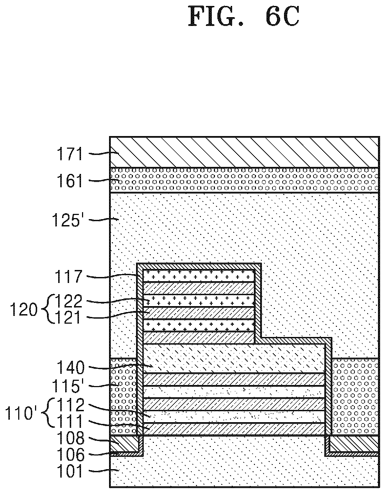

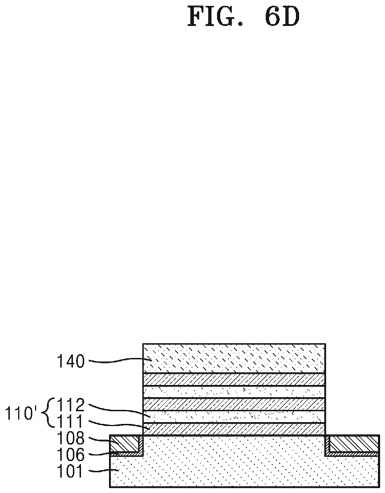

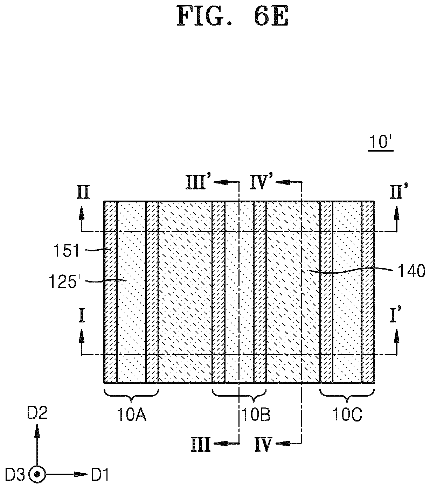

FIGS. 6A-6E illustrate the semiconductor device structure 10' in which the 2^{nd} channel stack 120' shown in FIGS. 5A, 5B, and 5D is patterned to provide spaces for forming 2^{nd} source/drain regions therein between the 1^{st} semiconductor stack 10A, the 2^{nd} semiconductor stack 10B and the 3^{rd} semiconductor stack 10C, according to one or more embodiments.

Referring to FIGS. 6A-6E, the 2^{nd} channel stack 120' shown in FIGS. 5A, 5B, and 5D may be etched down through the 1^{st} opening O1 and the 2^{nd} opening O2 using the 1^{st} to 3^{rd} semiconductor stacks 10A, 10B and 10C obtained in the previous step as masking structure to obtain three 2^{nd} channel structures 120 respectively included in the three semiconductor stack 10A, the 2^{nd} semiconductor stack 10B and the 3^{rd} semiconductor stack 10C.

By this etching operation, a top surface of the middle isolation structure 140 and side surfaces of the each 2^{nd} channel structures 120 may be exposed through the 1^{st} opening O1 and the 2^{nd} opening O2. For example, two opposite side surfaces of each of the 2^{nd} sacrificial layers 121 and two opposite side surfaces of each of the 2^{nd} channel layers 122 in the 2^{nd} channel structure 120 of the 2^{nd} semiconductor stack 10B may be exposed through the 1^{st} opening O1 and the 2^{nd} opening O2, respectively. Further, a right side surface of each of the 2^{nd} sacrificial layers 121 and a right side surface of each of the 2^{nd} channel layers 122 in the 2^{nd} channel structure 120 of the 1^{st} semiconductor stack 10A may be exposed through the 1^{st} opening O1, and a left side surface of each of the 2^{nd} sacrificial layers 121 and a left side surface of each of the 2^{nd} channel layers 122 in the 2^{nd} channel structure 120 of the 3^{rd} semiconductor stack 10C may be exposed through the 2^{nd} opening O2.

Further, the etching operation in this step may be performed through, for example, dry etching such as reactive ion etching (RIE), not being limited thereto such that, in each of the 1^{st} opening O1 and 2^{nd} opening O2, the side surfaces of the 2^{nd} sacrificial layers 121 and the 2^{nd} channel layers 122 are vertically aligned or coplanar with each other and with a side surface of the gate spacer 151. As will be described later, 2^{nd} source/drain regions may be formed based on the 2^{nd} channel layers 122 of the 1^{st} semiconductor stack 10A, the 2^{nd} semiconductor stack 10B and the 3^{rd} semiconductor stack 10C exposed through the 1^{st} opening O1 and the 2^{nd} opening O2.

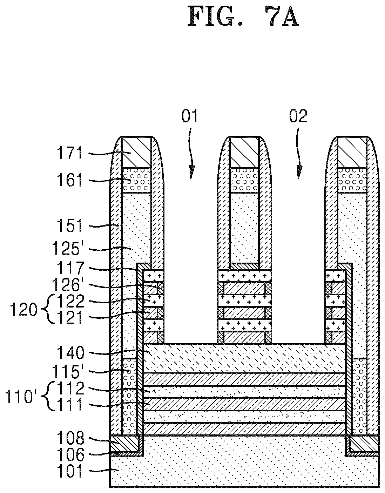

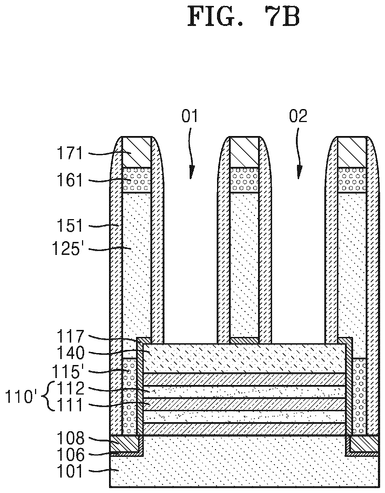

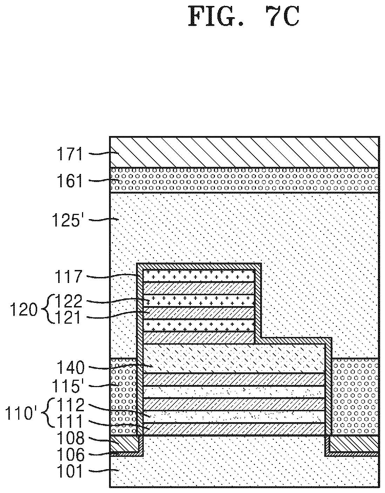

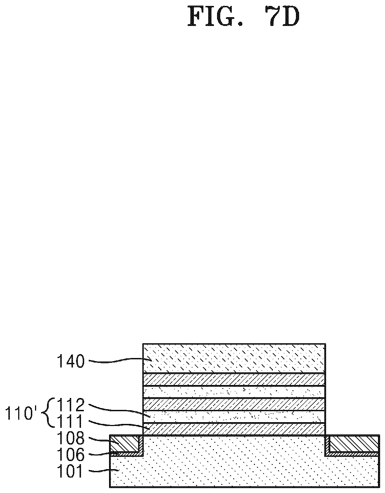

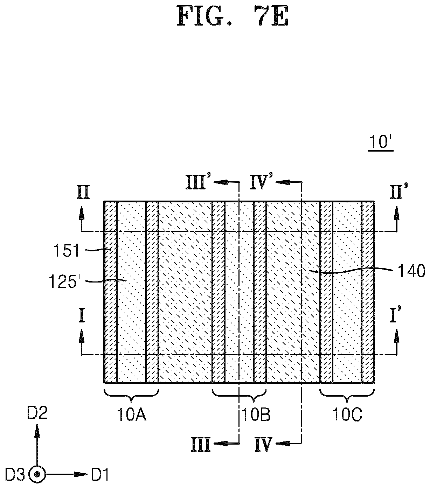

FIGS. 7A-7E illustrate the semiconductor device structure 10' in which each of the 2^{nd} sacrificial layers 121 is partially etched at the side surface thereof to form a sacrificial spacer 126' on the etched side surface, according to one or more embodiments.

Referring to FIGS. 7A-7E, a selective etching operation may be performed on the side surfaces of the 2^{nd} sacrificial layers 121 formed of silicon (Si) to pull back a portion of each of the 2^{nd} sacrificial layers 121 against the 2^{nd} channel layers 122 formed of silicon germanium (SiGe) and the middle isolation structure 140 formed of silicon nitride (e.g., SiBCN, SiCN, SiOCN, SiN, etc.), and the sacrificial spacers 126' may be formed in spaces where the portions of the 2^{nd} sacrificial layers 121 are removed.

For the selective etching operation in this step, dry etching or wet etching may be performed using an etchant, for example, sulfur hexafluoride (SF), tetramethylammonium hydroxide (TMAH), or potassium hydroxide (KOH), not being limited thereto, which may etch the 2^{nd} sacrificial layers 121 of Si against the 2^{nd} channel layers 122 of SiGe and the middle isolation structure 140 of silicon nitride (e.g., SiBCN, SiCN, SiOCN, SiN, etc.). For the formation of the sacrificial spacers 126', a material such as silicon nitride (e.g., SiN, SiBCN, SiCN, SiOCN, etc.), which may be different from that of the middle isolation structure 140, may be deposited through, for example, ALD, PVD, PEALD, CVD, PECVD, or a combination thereof, not being limited thereto, so that side surfaces of the gate spacer 151, the 2^{nd} channel layers 122 and the sacrificial spacers 126' may be vertically aligned or coplanar with each other in the openings O1 and O2.

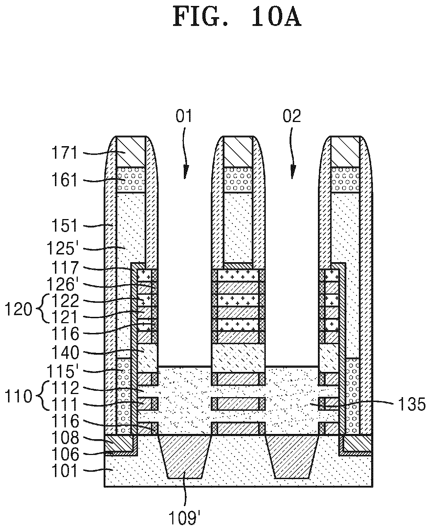

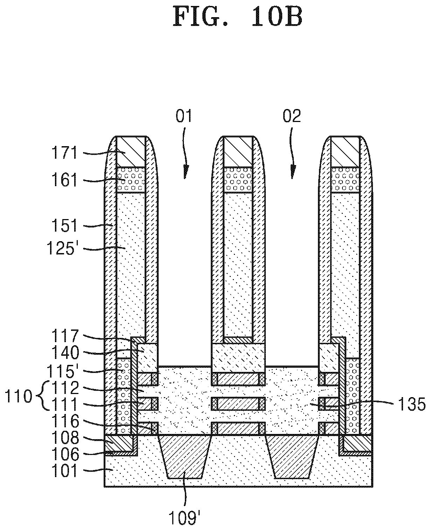

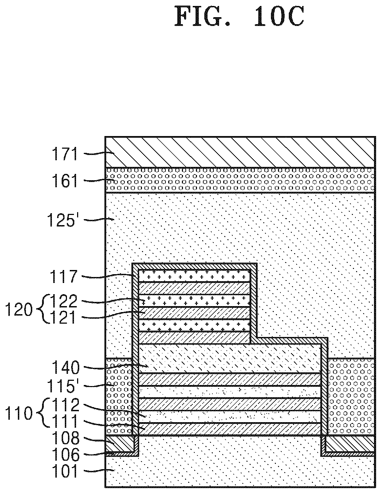

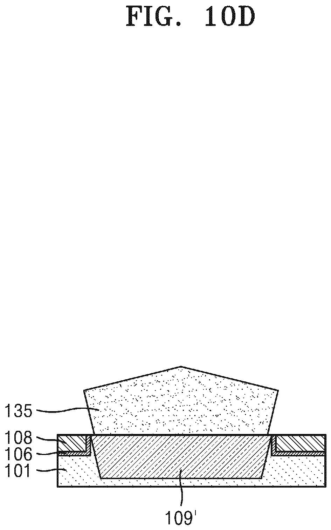

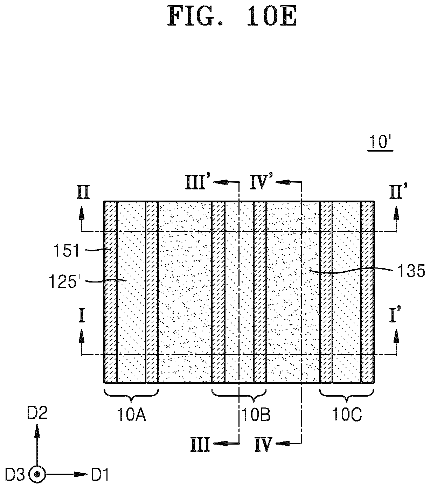

The formation of the sacrificial spacers 126' of silicon nitride on side surfaces of the etched 2^{nd} sacrificial layers 121 of Si may performed to prevent epitaxial growth of Si from the 2^{nd} sacrificial layers 121 when 1^{st} source/drain regions are formed from the 1^{st} channel layers 112 of Si in a later step (FIGS. 10A-10E).

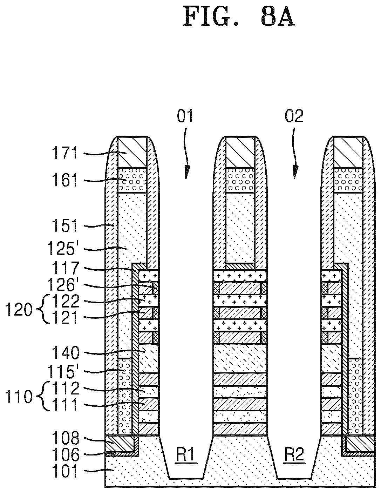

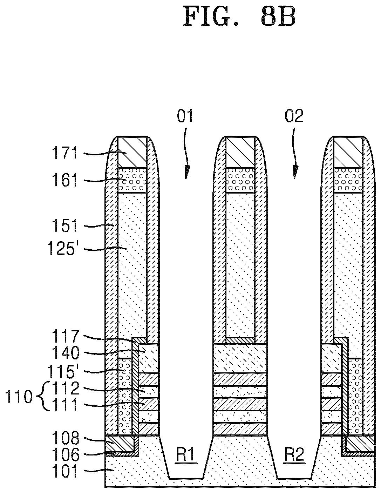

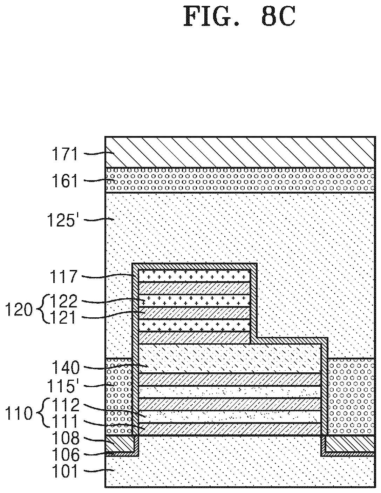

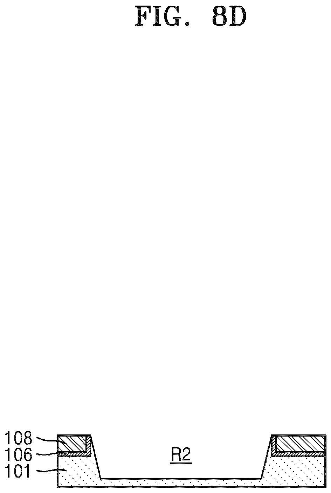

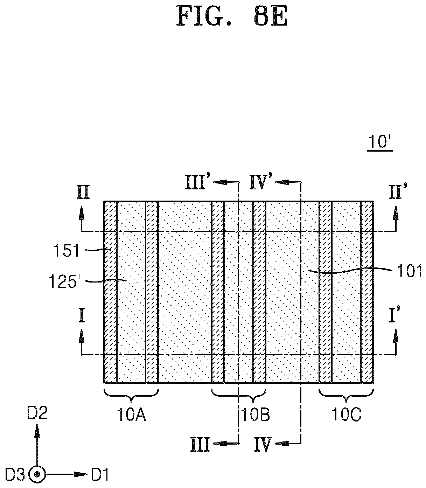

FIGS. 8A-8E illustrate the semiconductor device structure 10' in which the 1^{st} channel stack 110' shown in FIGS. 7A-7D and the substrate 101 therebelow are patterned to provide spaces for forming 1^{st} source/drain regions and placeholder structures therein between the 1^{st} semiconductor stack 10A, the 2^{nd} semiconductor stack 10B and the 3^{rd} semiconductor stack 10C, according to one or more embodiments.

Referring to FIGS. 8A-8E, the middle isolation structure 140 and the 1^{st} channel stack 110' shown in FIGS. 7A-7D therebelow on the substrate 101 may be etched down through the 1^{st} opening O1 and the 2^{nd} opening O2 using the 1^{st} semiconductor stack 10A, the 2^{nd} semiconductor stack 10B and the 3^{rd} semiconductor stack 10C as masking structure to obtain three middle isolation structures 140 and three 1^{st} channel structures 110 respectively included in the 1^{st} semiconductor stack 10A, the 2^{nd} semiconductor stack 10B and the 3^{rd} semiconductor stack 10C. Further, the substrate 101 of which a top surface is exposed by the etching of the 1^{st} channel stack 110' shown in FIGS. 7A-7D may be etched down to form a 1^{st} recess R1 and a 2^{nd} recess R2 in the substrate 101. Thus, the 1^{st} opening O1 and the 2^{nd} opening O2 formed by etching the 1^{st} channel stack 110' shown in FIGS. 7A-7D and the 2^{nd} channel stack 120' shown in FIGS. 5A, 5B, and 5D may be connected to the 1^{st} recess R1 and the 2^{nd} recess R2, respectively.

The etching operation in this step may be performed through, for example, dry etching such as reactive ion etching (RIE), not being limited thereto, such that, in each of the extended 1^{st} opening O1 and the extended 2^{nd} opening O2, side surfaces of the 1^{st} sacrificial layers 111, the 1^{st} channel layers 112 and the middle isolation structure 140 may be vertically aligned or coplanar with the side surfaces of the 2^{nd} channel layers 122, the sacrificial spacers 126' and the gate spacer 151.

As will be described later, the 1^{st} channel stack 110' shown in FIGS. 7A-7D may be patterned in this step to provide spaces for forming 1^{st} source/drain regions based on the 1^{st} channel layers 112 exposed through the 1^{st} opening O1 and the 2^{nd} opening O2. Further, the substrate 101 may be etched to form the 1^{st} recess R1 and the 2^{nd} recess R2 where placeholder structures for backside contact structures of 1^{st} source/drain regions are to be formed in a next step.

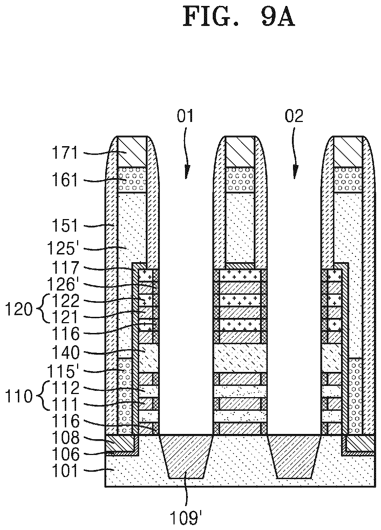

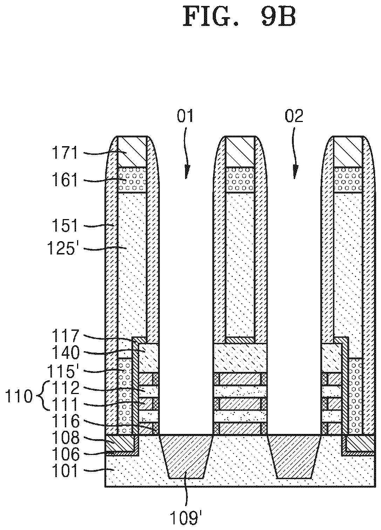

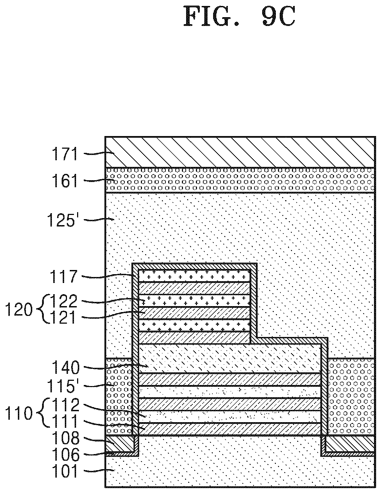

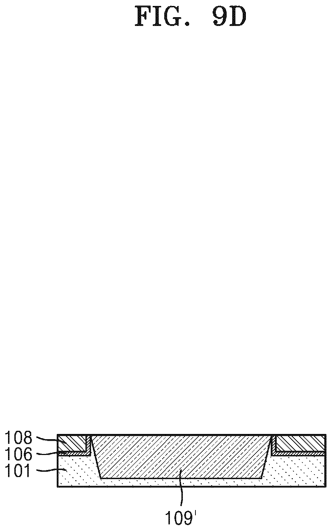

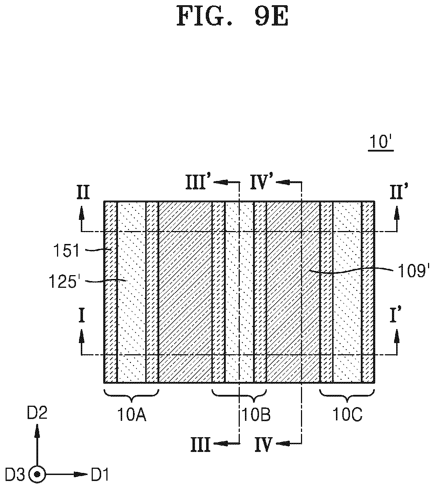

FIGS. 9A-9E illustrate the semiconductor device structure 10' in which each of the 1^{st} sacrificial layers 111 and the 2^{nd} channel layers 122 is partially etched at a side surface thereof to form a 1^{st} inner spacer 116 on the etched side surface, and further, a placeholder structure 109' is formed in each of the 1^{st} recess R1 and the 2^{nd} recess R2 obtained in the previous step, according to one or more embodiments.

Referring to FIGS. 9A-9E, a selective etching operation may be performed on the side surfaces of the 1^{st} sacrificial layers 111 and the 2^{nd} channel layers 122 formed of SiGe to pull back a portion of each of these layers. Further, the 1^{st} inner spacers 116 may be formed in spaces where the portions of the 1^{st} sacrificial layers 111 and the 2^{nd} channel layers 122 are removed, respectively. By this selective etching operation, a length of the 2^{nd} channel layers 122 becomes smaller than a length of the 1^{st} channel layers 112. For example, as shown in FIG. 1F, the 2^{nd} channel layers 122 may have the 2^{nd} length L21 which is smaller than the 1^{st} length L11 of the 1^{st} channel layers 112.

The 1^{st} inner spacers 116 formed on the side surfaces of the 1^{st} sacrificial layers 111 may isolate a 1^{st} gate structure to replace the 1^{st} sacrificial layers 111 from 1^{st} source/drain regions to be formed from the 1^{st} channel layers 112 when the 3D-stacked semiconductor device is completed, and the 1^{st} inner spacers 116 formed on the side surfaces of the 2^{nd} sacrificial layers 121 will be removed along with the sacrificial spacers 126' for an additional frontside process in a later step.

For the selective etching operation in this step, dry etching or wet etching may be applied using an etchant, for example, chlorine/oxygen (Cl₂/O₂), a mixture of hydrofluoric acid (HF) and ammonium fluoride (NH₄F), not being limited thereto, which may etch the 1^{st} sacrificial layers 111 and the 2^{nd} channel layers 122 of SiGe against the 1^{st} channel layers 112 of Si, the sacrificial spacers 126' of silicon nitride and the middle isolation structure 140 of silicon nitride. For the formation of the 1^{st} inner spacers 116, a material such as silicon nitride which may form the sacrificial spacer 126' may be deposited through, for example, ALD, PVD, PEALD, CVD, PECVD, or a combination thereof, not being limited thereto, so that side surfaces of the 1^{st} inner spacers 116 may be vertically aligned or coplanar with the side surfaces of the 1^{st} channel layers 112, the middle isolation structure 140, the sacrificial spacer 126' and the gate spacer 151 in each of the 1^{st} opening O1 and the 2^{nd} opening O2.

After the 1^{st} inner spacers 116 are formed as above, the placeholder structures 109' may be formed in the 1^{st} recess R1 and the 2^{nd} recess R2 to reserve spaces for formation of respective backside contact structures in a later step. The backside contact structures may be connected to bottom surfaces of 1^{st} source/drain regions to be formed thereabove, respectively, in a later step. The formation of the placeholder structures 109' may be performed through, for example, ALD, PVD, PEALD, CVD, PECVD, or a combination thereof, followed by planarization so that a top surface of each of the placeholder structures 109' may be at a level below a bottom surface of the lowermost 1^{st} channel layer 112. A material forming the placeholder structure 109' may be, for example, silicon germanium (SiGe), not being limited thereto.

FIGS. 10A-10E illustrate the semiconductor device structure 10' in which 1^{st} source/drain regions 135 are formed from the 1^{st} channel layers 112 in the 1^{st} opening O1 and the 2^{nd} opening O2, according to one or more embodiments.

Referring to FIGS. 10A-10E, the 1^{st} source/drain regions 135 may be epitaxially grown from the 1^{st} channel layers 112 of silicon (Si) exposed in the 1^{st} opening O1 and the 2^{nd} opening O2, while the 1^{st} sacrificial layers 111, the 2^{nd} sacrificial layers 121 and the 2^{nd} channel layers 122 are covered by the 1^{st} inner spacers 116 and the sacrificial spacers 126', respectively.

The 1^{st} source/drain regions 135 may also be formed silicon (Si), and may be doped with impurities such as phosphorus (P), arsenic (As), antimony (Sb), etc., and thus, a 1^{st} transistor to be formed based on the 1^{st} channel layers 112 and the 1^{st} source/drain regions 135 at the 1^{st} level will be an n-type transistor.

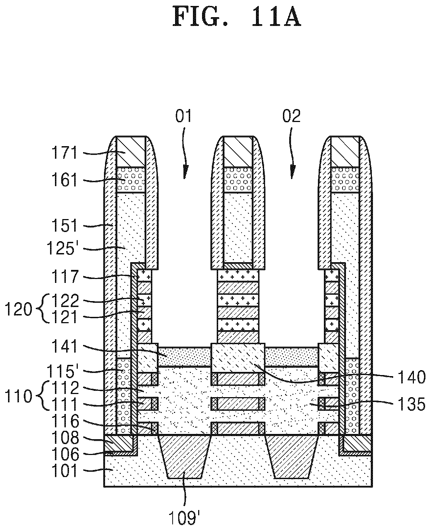

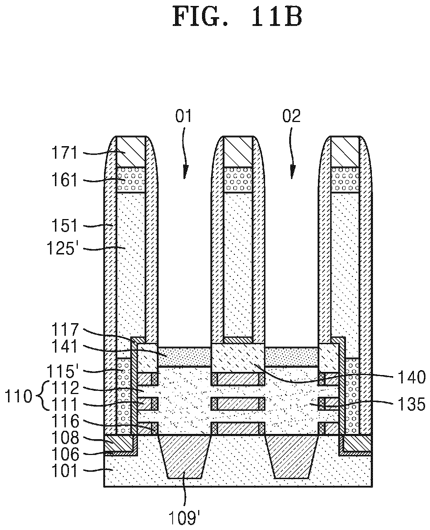

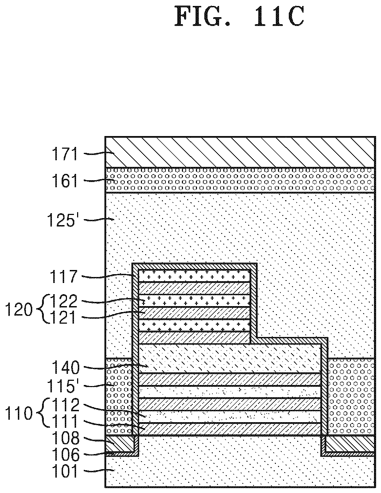

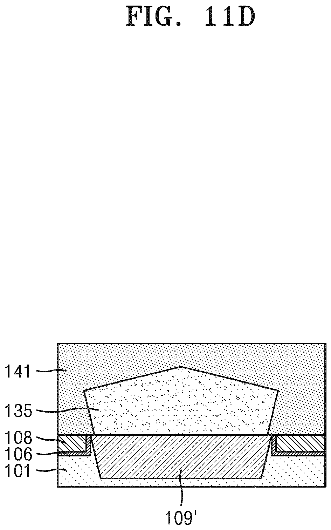

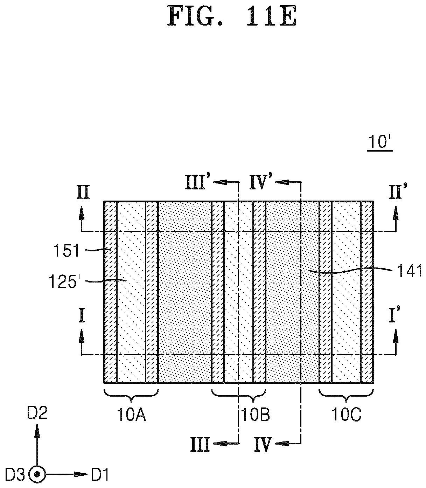

FIGS. 11A-11E illustrate the semiconductor device structure 10' in which a frontside isolation structure 141 is formed on the 1^{st} source/drain regions 135, and the sacrificial spacers 126' and the 1^{st} inner spacers 116 on the side surfaces of the 2^{nd} channel structures 120 are removed, according to one or more embodiments.

Referring to FIGS. 11A-11E, the 1^{st} frontside isolation structure 141 may be formed to isolate the 1^{st} source/drain regions 135 from other circuit elements including 2^{nd} source/drain regions to be formed at the 2^{nd} level in a later step. The 1^{st} frontside isolation structure 141 may be formed through, for example, deposition of silicon oxide (e.g., SiO or SiO₂), not being limited thereto, such as PVD, CVD, PECVD, or their combination, followed by planarization (e.g., CMP) such that a top surface thereof is at a level below the bottom surface of the lowermost 2^{nd} channel layer 122 in each of the 1^{st} opening O1 and the 2^{nd} opening O2.

Further, the sacrificial spacers 126' on the side surfaces of the 2^{nd} sacrificial layers 121 and the 1^{st} inner spacers 116 on the side surfaces of the 2^{nd} channel layers 122 may be removed through dry etching or wet etching using an etchant, for example, chlorotrifluoromethane/oxygen (CHF₃/O₂) or hot phosphoric acid (H₃PO₄), not being limited thereto, that may etch silicon nitride against silicon oxide. By this operation, the 2^{nd} sacrificial layers 121 and the 2^{nd} channel layers 122 may be exposed through the 1^{st} opening O1 and the 2^{nd} opening O2. Here, when the sacrificial spacers 126' and the 1^{st} inner spacers 116 are removed at the 2^{nd} level of the semiconductor device structure 10', each of the 1^{st} opening O1 and the 2^{nd} opening O2 may become wider at the 2^{nd} level than at the 1^{st} level. Thus, when a 2^{nd} source/drain region is epitaxially grown from the 2^{nd} channel layers 122 in a later step, a length of the 2^{nd} source/drain region may become greater than a length of the 1^{st} source/drain region 135 grown from the 1^{st} channel layers 112 at the 1^{st} level.

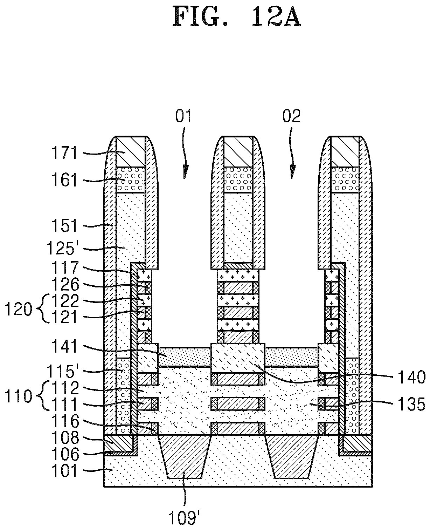

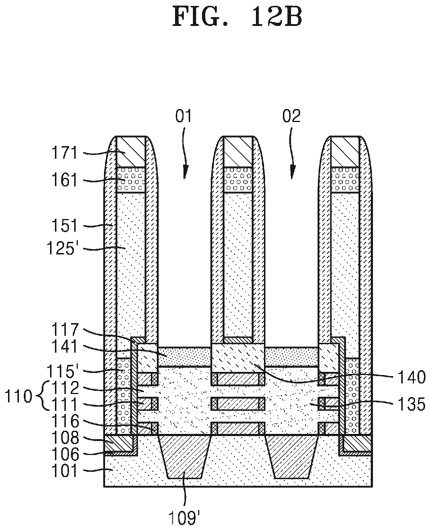

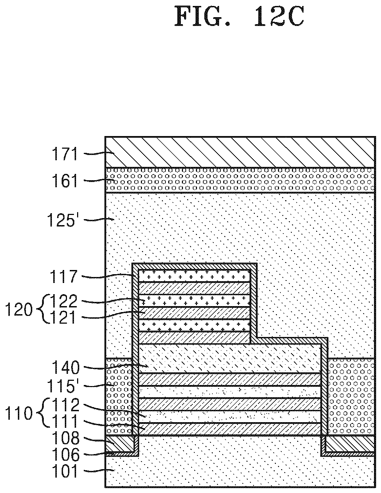

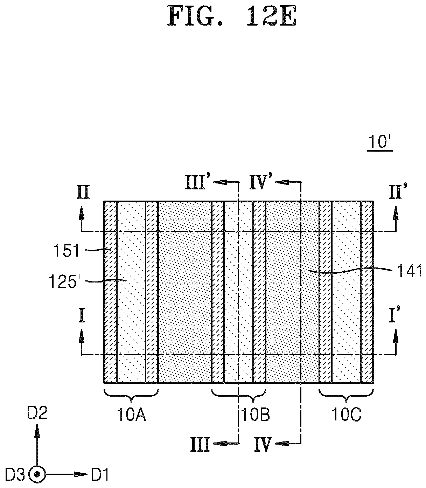

FIGS. 12A-12E illustrate the semiconductor device structure 10' in which each of the 2^{nd} sacrificial layers 121 is partially etched again at the side surface thereof to form a 2^{nd} inner spacer 126 on the etched side surface, according to one or more embodiments.

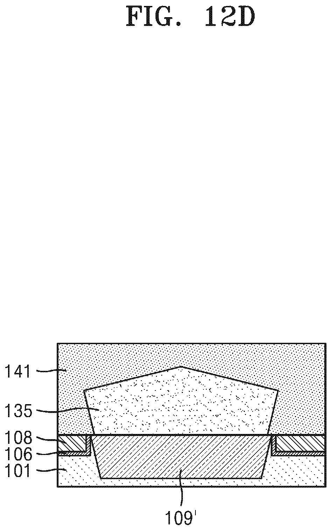

Referring to FIGS. 12A and 12D, a selective etching operation may be performed on the side surfaces of the 2^{nd} sacrificial layers 121 formed of Si to pull back a portion of each of the 2^{nd} sacrificial layers 121 against the 2^{nd} channel layers 122 formed of SiGe and the frontside isolation structure 141 of silicon oxide. Subsequently, the 2^{nd} inner spacers 126 may be formed in spaces where the portions of the 2^{nd} sacrificial layers 121 are removed.

For the selective etching operation in this step, dry etching or wet etching may be performed using an etchant, for example, sulfur hexafluoride (SF), tetramethylammonium hydroxide (TMAH), or potassium hydroxide (KOH), not being limited thereto, which may etch the 2^{nd} sacrificial layers 121 of Si against the 2^{nd} channel layers 122 of SiGe and the frontside isolation structure 141 of silicon oxide. For the formation of the 2^{nd} inner spacers 126, a material such as silicon nitride (e.g., SiN, SiBCN, SiCN, SiOCN, etc.), which may be different from that of the gate spacer 151, may be deposited through, for example, ALD, PVD, PEALD, CVD, PECVD, or a combination thereof, not being limited thereto, so that side surfaces of the 2^{nd} channel layers 122 and the 2^{nd} inner spacers 126 may be vertically aligned or coplanar with each other in each of the 1^{st} opening O1 and the 2^{nd} opening O2.

The 2^{nd} inner spacers 126 may be formed on side surfaces of the etched 2^{nd} sacrificial layers 121 to isolate a 2^{nd} gate structure to replace the 2^{nd} sacrificial layers 121 in a later step from a 2^{nd} source/drain region to be formed from the 2^{nd} channel layers 122 also in a later step. Here, as the 2^{nd} sacrificial layers 121 are shortened again by the etching operation in this step in addition to the previous etching operation described in reference to FIGS. 7A-7E, a length of the each of the 2^{nd} sacrificial layers 121 becomes smaller than a length of each of the 1^{st} sacrificial layers 111. Accordingly, a length of a 2^{nd} gate structure to replace the 2^{nd} sacrificial layers 121 will be smaller than a length of a 1^{st} gate structure to replace the 1^{st} sacrificial layers 111 in a later step.

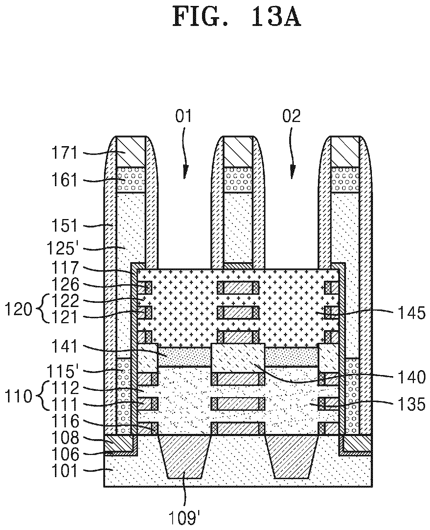

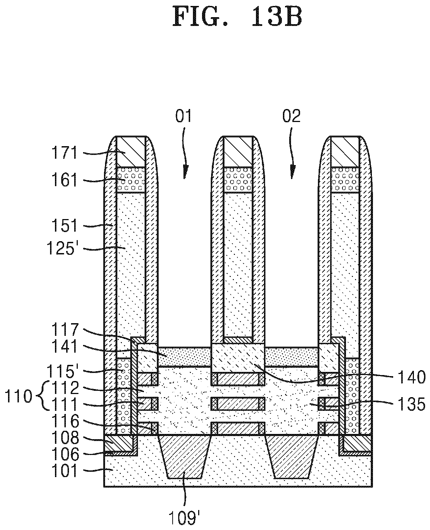

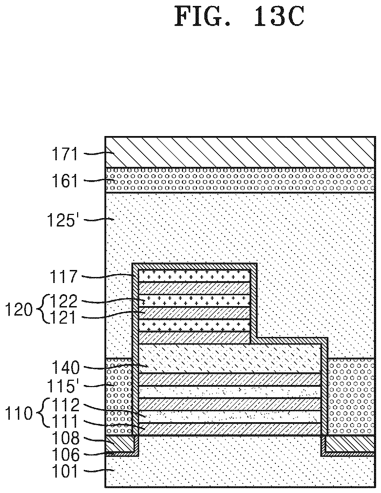

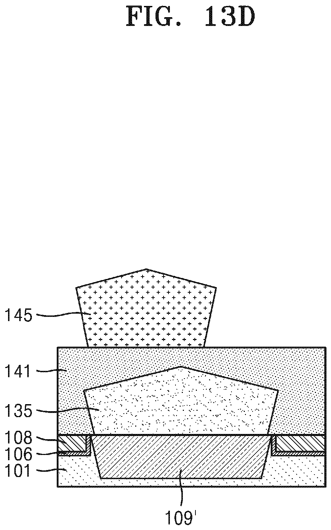

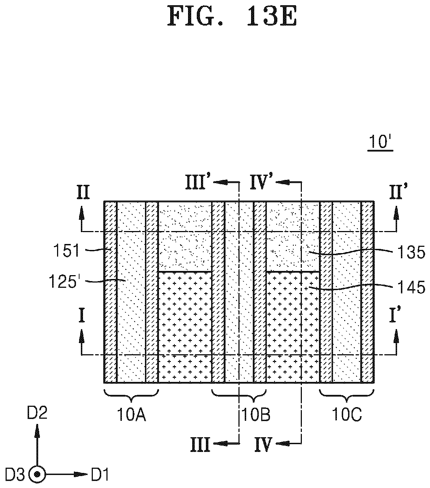

FIGS. 13A-13E illustrate the semiconductor device structure 10' in which 2^{nd} source/drain regions 145 are formed from the 2^{nd} channel layers 122 in the 1^{st} opening O1 and the 2^{nd} opening O2, according to one or more embodiments.

Referring to FIGS. 13A-13E, the 2^{nd} source/drain regions 145 may be epitaxially grown from the 2^{nd} channel layers 122 of SiGe exposed in the 1^{st} opening O1 and the 2^{nd} opening O2 on the frontside isolation structure 141, while the 2^{nd} sacrificial layers 121 of Si are covered by the 2^{nd} inner spacers 126. At this time, the 2^{nd} source/drain regions 145 may also be formed SiGe, and may be doped with impurities such as boron (b), gallium (Ga), indium (In), etc., and thus, a 2^{nd} transistor to be formed based on the 2^{nd} channel layers 122 and the 2^{nd} source/drain regions 145 at the 2^{nd} level will be a p-type transistor.

Here, each of the 2^{nd} source/drain regions 145 may be formed in each of the openings O1 and O2 at a wider portion in the D1 direction, that is, at the 2^{nd} level based on the 2^{nd} channel layers 122 having a smaller length, as described in reference to FIGS. 9A-9E and FIGS. 11A-11E. Thus, a length of the 2^{nd} source/drain region 145 may become greater than the 1^{st} source/drain region 135 at the 1^{st} level therebelow. For example, as shown in FIG. 1F, the 2^{nd} source/drain regions 145 may have the length 4^{th} L22 which is greater than the 3^{rd} length L12 of the 1^{st} source/drain regions 135.

However, each of the 2^{nd} source/drain regions 145 may have a smaller width than the 1^{st} source/drain region 135 when the 2^{nd} channel layers 122 have a smaller width than the 1^{st} channel layers 112, as described in reference to FIGS. 1A-1E.

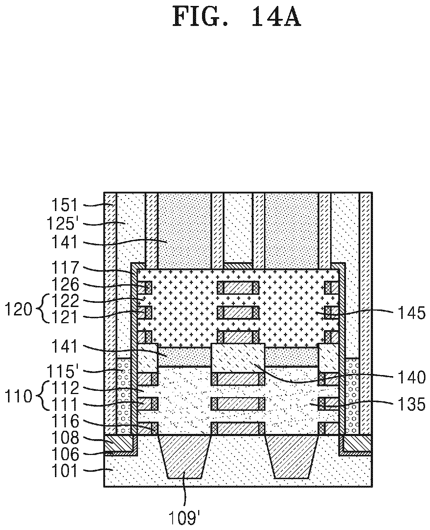

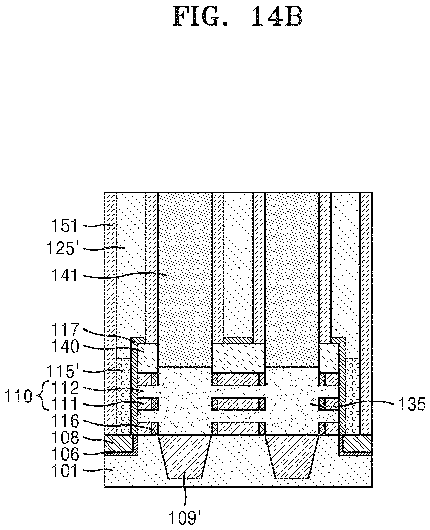

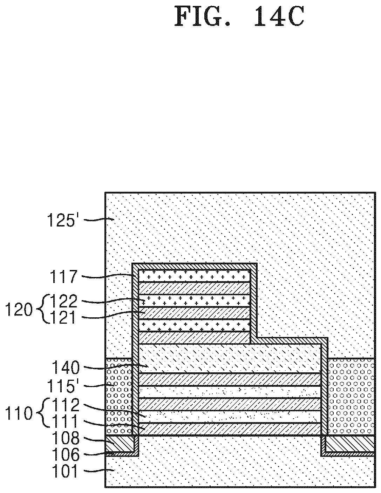

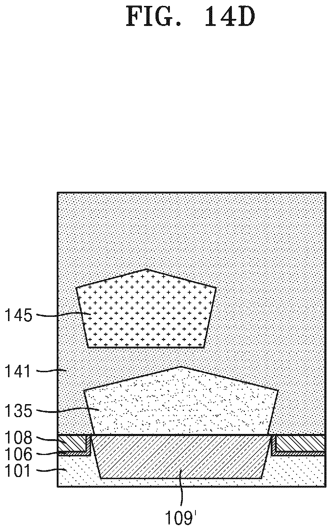

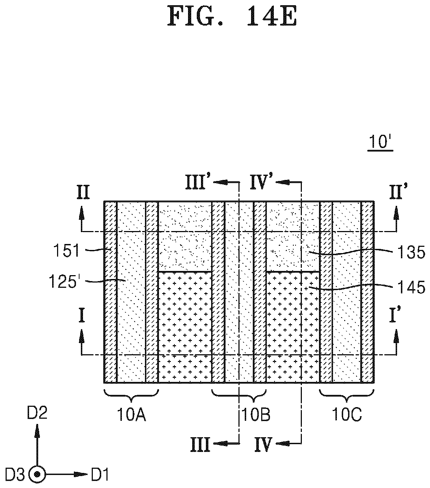

FIGS. 14A-14E illustrate the semiconductor device structure 10' in which the frontside isolation structure 141 is extendedly formed on the 2^{nd} source/drain regions 145, and the hard mask patterns 161 and the mask protection patterns 171 shown in FIGS. 13A-13C may be removed, according to one or more embodiments.

Referring to FIGS. 14A-14E, the frontside isolation structure 141 may be additionally formed to surround the 2^{nd} source/drain regions 145 to isolate the 2^{nd} source/drain regions 145 from the 1^{st} source/drain regions 135 and other circuit elements. Further, the hard mask patterns 161 and the mask protection patterns 171 shown in FIGS. 13A-13C may be removed from each of the 1^{st} semiconductor stack 10A, the 2^{nd} semiconductor stack 10B and the 3^{rd} semiconductor stack 10C to expose top surfaces of the 2^{nd} dummy gate structure 125' through the gate spacers 151 surrounding the 2^{nd} dummy gate structures 125'.

The additional formation of the frontside isolation structure 141 may be performed through, for example, deposition of silicon oxide (e.g., SiO or SiO₂), not being limited thereto, such as PVD, CVD, PECVD, or their combination. The removal of the hard mask patterns 161 and the mask protection patterns 171 shown in FIGS. 13A-13C may be performed through, for example, stripping, ashing, dry etching or wet etching, not being limited thereto, such that top surfaces of the gate spacers 151, the 2^{nd} dummy gate structure 125' and the frontside isolation structure 141 are horizontally aligned or coplanar with each other.

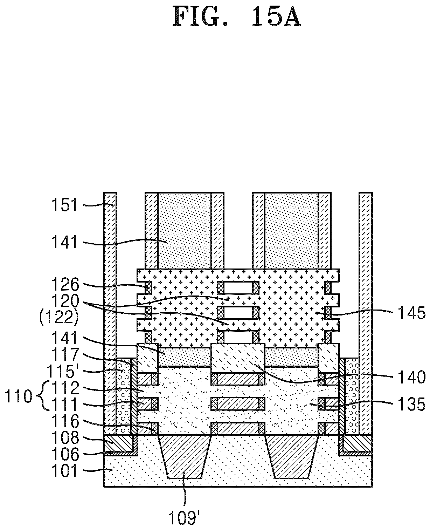

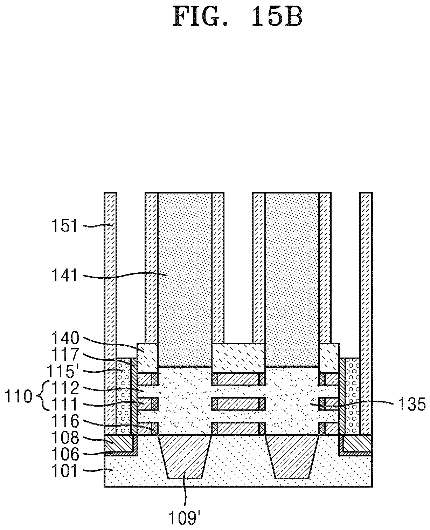

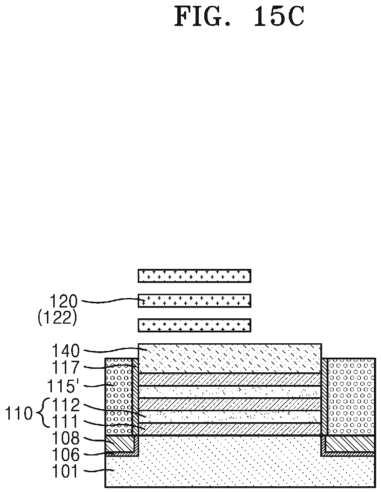

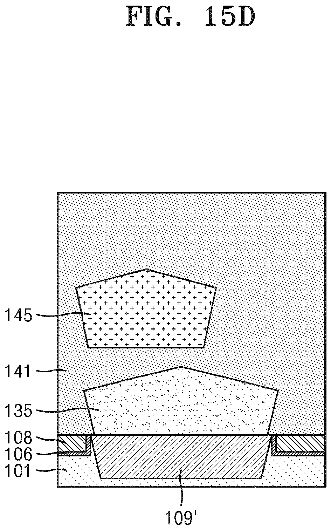

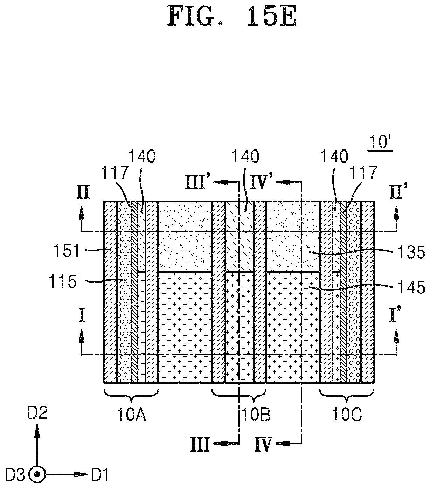

FIGS. 15A-15E illustrate the semiconductor device structure 10' in which the 2^{nd} dummy gate structure 125', an upper portion of the EG layer 117, and the 2^{nd} sacrificial layers 121 are removed, according to one or more embodiments.

Referring to FIGS. 15A-15E, the 2^{nd} dummy gate structure 125' of which the top surfaces are exposed in the previous step, the upper portion of the EG layer 117 surrounding the 2^{nd} channel structure 120, and the 2^{nd} sacrificial layers 121 shown in FIGS. 14A-14E may be removed through, for example, dry etching, wet etching, or a combination thereof, not being limited thereto, using an etchant, for example, as a mixture of nitric acid (HNO₃) and hydrofluoric acid (HF), not being limited thereto, to release the 2^{nd} channel layers 122 forming a 2^{nd} channel structure 120 of the semiconductor device structure 10'.

Thus, in the semiconductor device structure 10', the 2^{nd} channel layers 122 of SiGe surrounded by the 2^{nd} dummy gate structure 125' and the 2^{nd} sacrificial layers 121 shown in FIGS. 14A-14E may be released to an open space where a 2^{nd} gate structure is to be formed at the 2^{nd} level of the semiconductor device structure 10' in a next step.

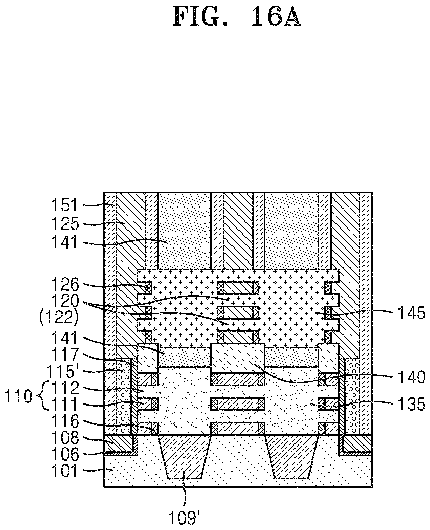

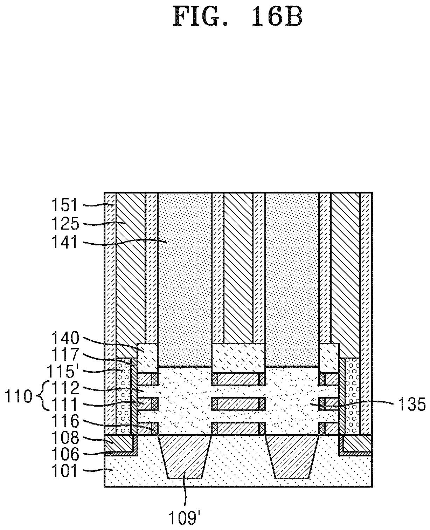

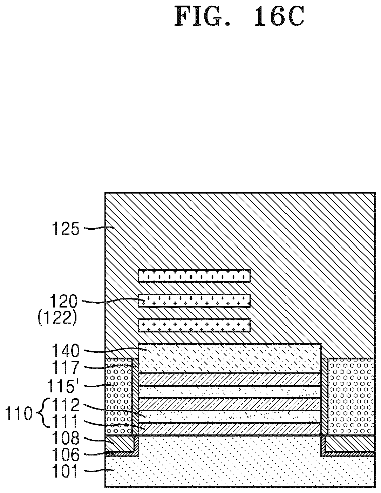

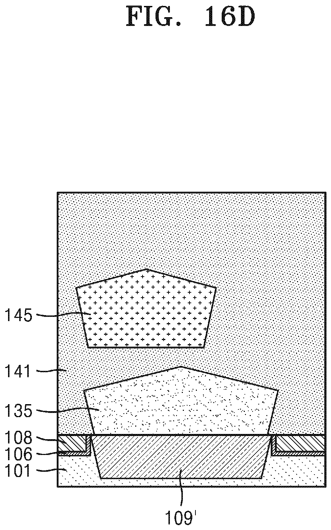

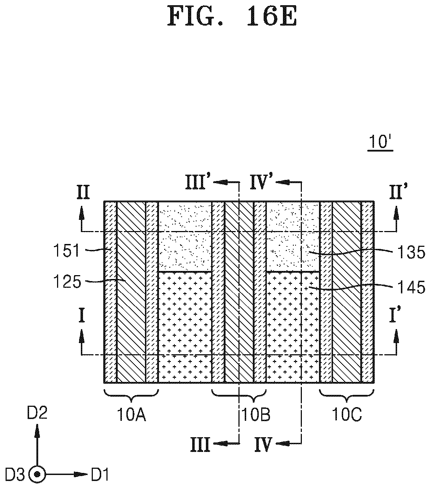

FIGS. 16A-16E illustrate the semiconductor device structure 10' in which a 2^{nd} gate structure 125 is formed in a space provided by the removal of the 2^{nd} dummy gate structure 125', the upper portion of the EG layer 117, and the 2^{nd} sacrificial layers 121 shown in FIGS. 14A-14E, according to one or more embodiments.

Referring to FIGS. 16A-16E, the 2^{nd} gate structure 125 surrounding the 2^{nd} channel layers 122 may be formed in the space obtained by the removal of the 2^{nd} dummy gate structure 125', the upper portion of the EG layer 117, and the 2^{nd} sacrificial layers 121 shown in FIGS. 14A-14E through, for example, PVD, CVD, PECVD, ALD, PEALD, or a combination thereof, not being limited thereto.

For the formation of the 2^{nd} gate structure 125, a gate dielectric layer including an interfacial layer and a high-k dielectric layer may be first layered to surround the 2^{nd} channel layers 122. The interfacial layer may be provided to protect the 2^{nd} channel layers 122 and facilitate growth of the high-k dielectric layer thereon, and the high-k dielectric layer may be formed to allow an increased gate capacitance without associated current leakage at the 2^{nd} gate structure 125. For these purposes, the interfacial layer may be formed of an oxide material such as silicon oxide (SiO or SiO₂) and/or silicon oxynitride (SiON), not being limited thereto, and the high-k dielectric layer may be formed of a high-k material such as Hf, Al, Zr, La, Mg, Ba, Ti, Pb, and/or a combination thereof, not being limited thereto.

On the gate dielectric layer may be formed a work-function metal layer, and a gate electrode. The work-function metal layer may control a threshold voltage of a 2^{nd} transistor formed by the 2^{nd} gate structure 125. For this purpose, the work-function metal layer may include a metal such as Ti, Ta, Al, W, TiN, WN, TiAl, TiAlN, TaN, TiC, TaC, TiAlC, TaCN, TaSiN, and/or a combination thereof, not being limited thereto. When the 2^{nd} gate structure 125 is formed as a gate structure for a p-type transistor, it may include TiN, and when the 2^{nd} gate structure 125 is formed as a gate structure for an n-type transistor, it may include Al or TiC. The gate electrode may be formed of Cu, W, Al, Ru, Mo, Co, and/or a combination thereof, not being limited thereof.

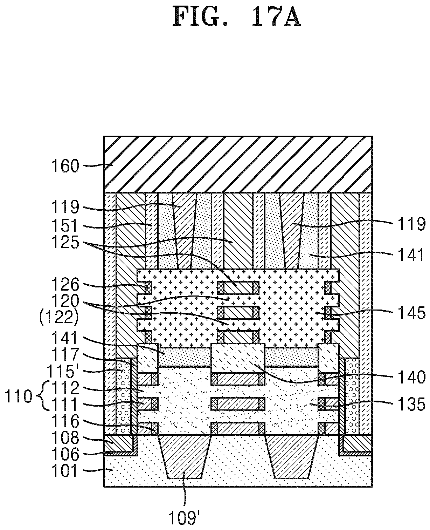

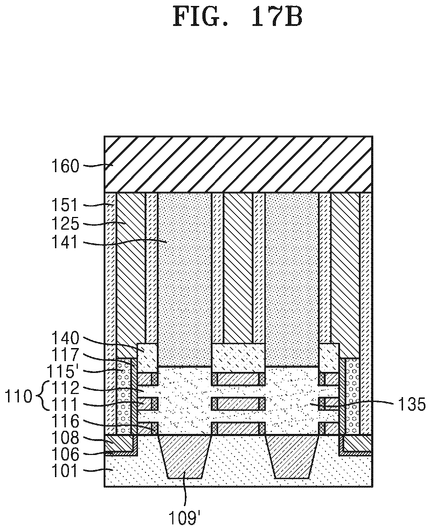

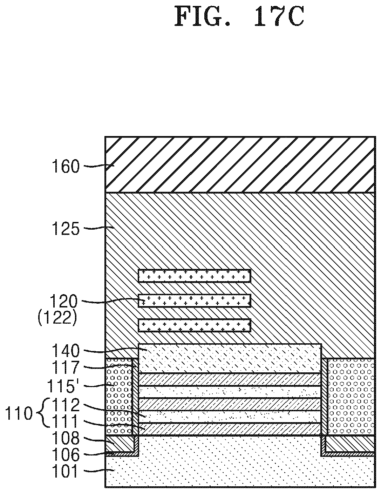

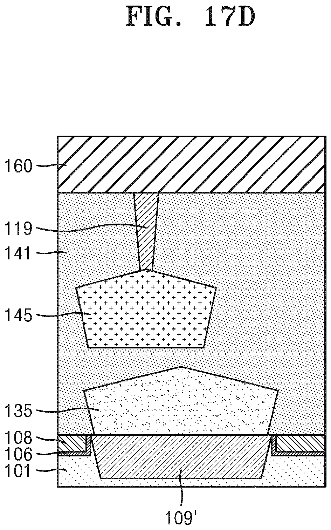

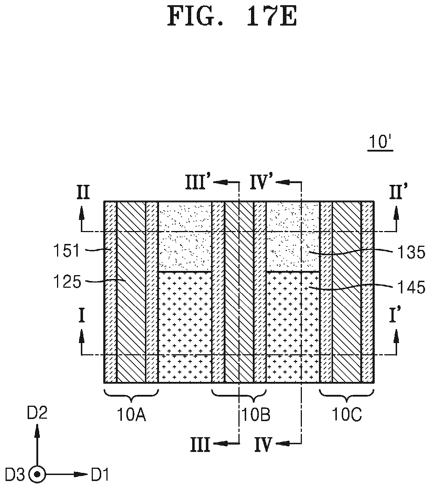

FIGS. 17A-17E illustrate the semiconductor device structure 10' in which a frontside contact structure 119 and a BEOL layer 160 are formed, according to one or more embodiments.

Referring to FIGS. 17A-17E, the frontside contact structures 119 may be formed through, for example, dry etching or wet etching on the frontside isolation structure 141 to form holes therein exposing top surfaces of the 2^{nd} source/drain regions 145, and forming the frontside contact structures 119 in the holes through, for example, CVD, PVD, PECVD, or a combination thereof, so that the top surfaces of the 2^{nd} source/drain regions 145 may be connected to the frontside contact structures 119', respectively. Further, the BEOL layer 160 including one or more metal lines may be formed on a top surface of the semiconductor device structure 10' obtained in the previous step such that the frontside contact structures 119' are connected to the metal lines of the BEOL layer 160. The formation of the BEOL layer 160 may be performed through, for example, a damascene process, not being limited thereto.

Thought the frontside contact structures 119 and the BEOL layer 160, the 2^{nd} source/drain regions 145 may be connected to one or more voltage sources or other circuit elements for internal routing purposes. The frontside contact structures 119 and the metal lines included in the BEOL layer 160 may be formed of a metal such as Cu, W, Al, Ru, Mo, Co, and the like, and various compounds or alloys thereof.

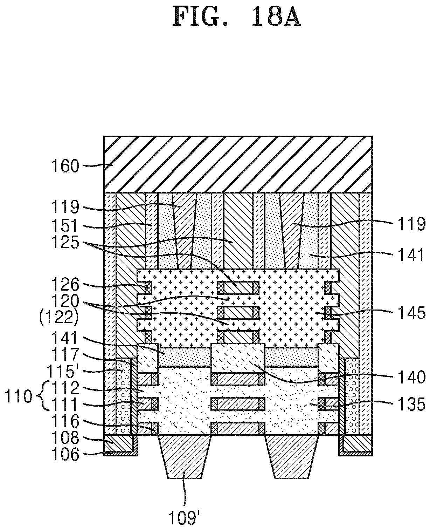

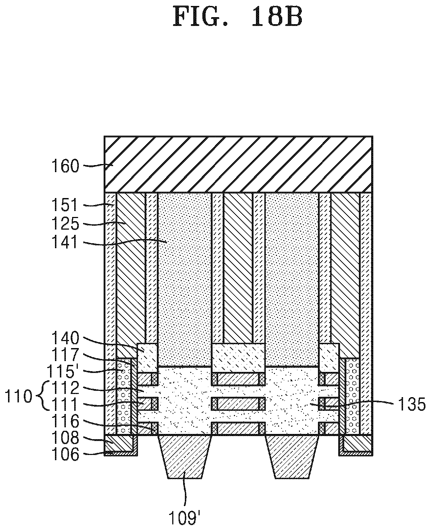

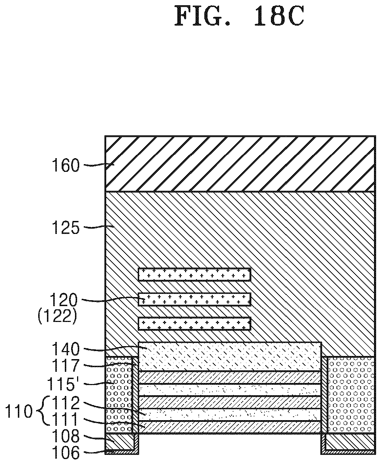

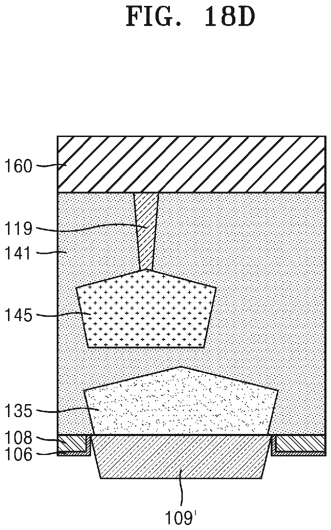

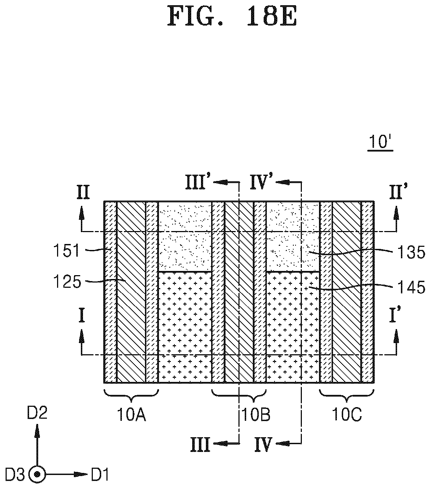

FIGS. 18A-18E illustrate the semiconductor device structure 10' in which the substrate 101 shown in FIGS. 17A-17E is removed therefrom, according to one or more embodiments.

Referring to FIGS. 18A-18E, the substrate 101 shown in FIGS. 17A-17E may be removed to expose the placeholder structures 109' formed on bottom surfaces of the 1^{st} source/drain regions 135, respectively. The removal of the substrate 101 may be performed through, for example, wet etching using an etchant, for example, sulfur hexafluoride (SF), tetramethylammonium hydroxide (TMAH), or potassium hydroxide (KOH), not being limited thereto, which may selectively etch the substrate 101 of Si against the placeholder structures 109' of SiGe and the STI liner 106 of silicon nitride (e.g., SiN or Si₃N₄).

Although not shown in the drawings, the substrate removal process in this step and subsequent steps to be described hereafter may be performed after flipping upside down the semiconductor device structure 10' obtained in the previous step.

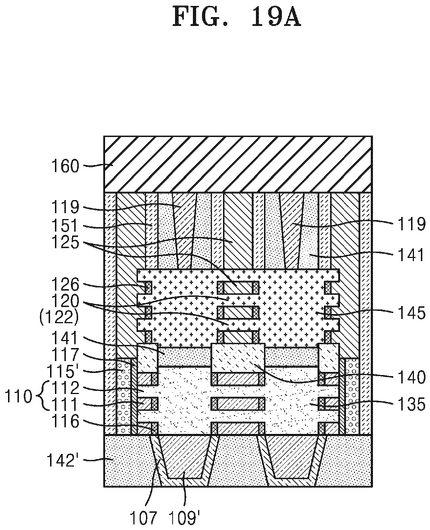

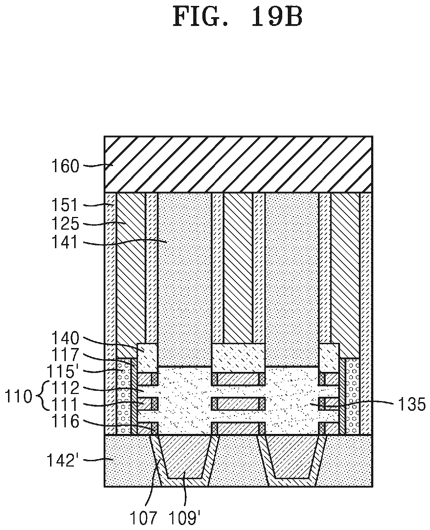

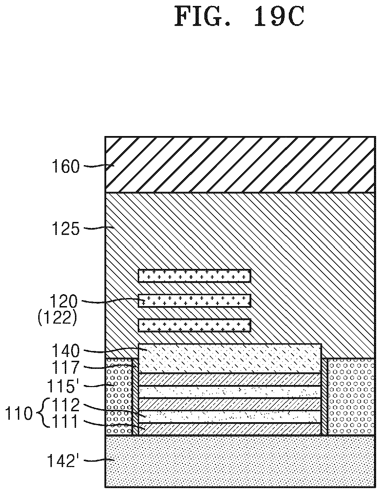

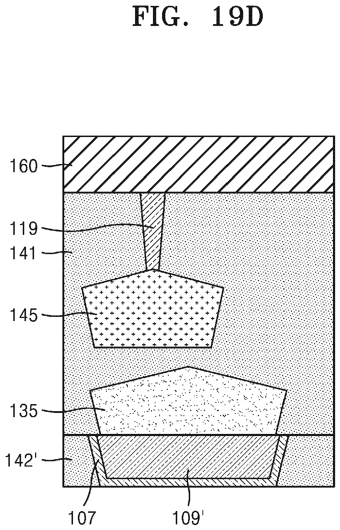

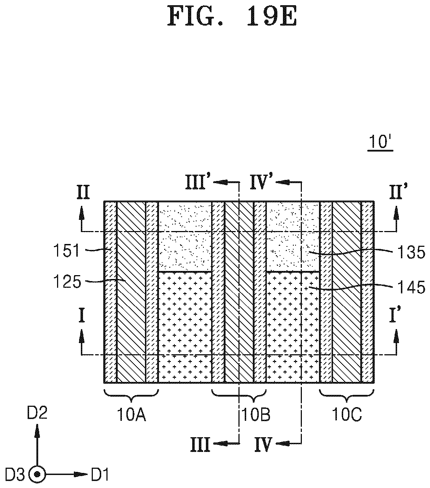

FIGS. 19A-19E illustrate the semiconductor device structure 10' in which contact spacers 107 are formed on side surfaces of the placeholder structures 109' and an initial backside isolation structure 142' is formed to surround the placeholder structures 109' with the contact spacers 107 thereon, according to one or more embodiments.

Referring to FIG. 19A-19E, the STI structure 108 and the STI liner 106 shown in FIGS. 18A-18E may be removed through, for example, dry etching or wet etching, and the contact spacer 107 including silicon nitride (e.g., SiN, SiBCN, SiCN, SiOCN, etc.), not being limited thereto, may be formed on a side surface of each of the placeholder structures 109' through, for example, ALD, PEALD, PVD, CVD, PECVD, or a combination thereof. Further, the initial backside isolation structure 142' including silicon oxide (SiO, SiO₂, or so on) may be formed to surround each of the placeholder structures 109' with the contact spacer 107 thereon. In addition, a bottom surface of each of the placeholder structures 109' may be capped by the same material forming the contact spacer 107 so that the contact spacer 107 may entirely surround the bottom surface and a side surface of each placeholder structure 109'.

As will be described later, the contact spacer 107 may be formed to facilitate self-aligned deposition of a metal or metal compound to form a backside contact structure replacing the placeholder structure 109'. The capping of the placeholder structure 109' may be performed to protect the placeholder structure 109' from a subsequent process of forming a gate structure at the 1^{st} level of the semiconductor device structure 10'.

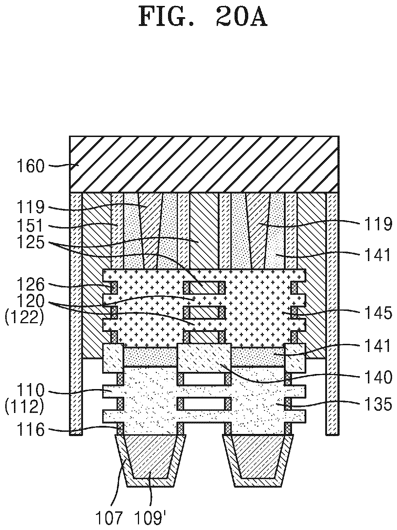

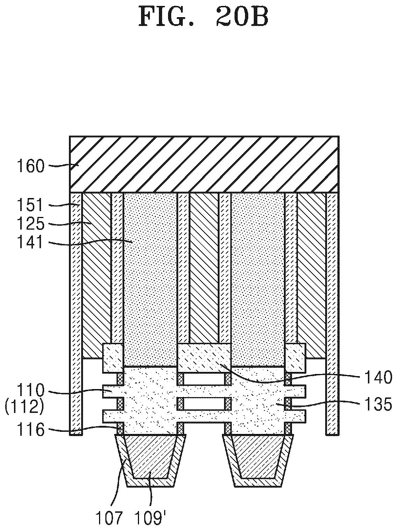

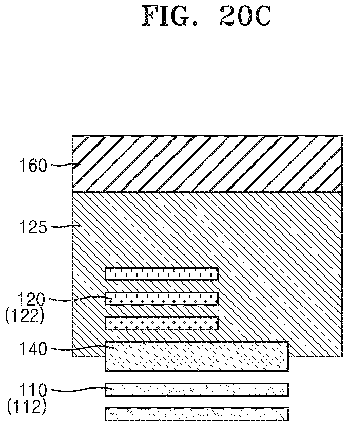

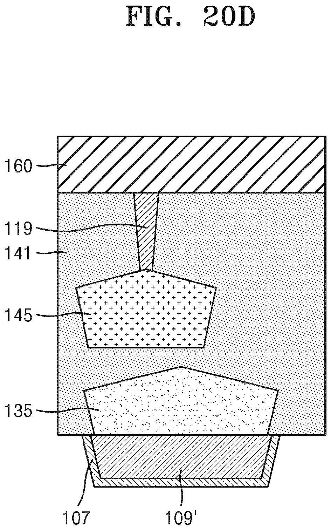

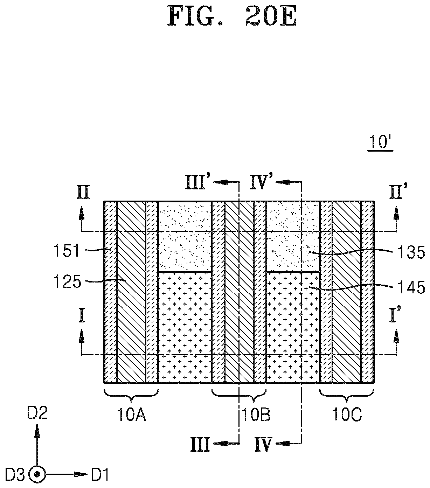

FIGS. 20A-20E illustrate the semiconductor device structure 10' in which the initial backside isolation structure 142', the remaining EG layer 117, the 1^{st} dummy gate structure 115' and the 1^{st} sacrificial layers 111 shown in FIGS. 19A-19E are removed, according to one or more embodiments.

Referring to FIGS. 20A-20E, the initial backside isolation structure 142' shown in FIGS. 19A-19E may be removed through wet etching or dry etching using an etchant, for example, carbon tetrafluoride (CF₄) or a mixture of hydrofluoric acid (HF) and ammonium fluoride (NH₄F), not being limited thereto, which may selectively remove silicon oxide (e.g., SiO, SiO₂, etc.) forming the initial backside isolation structure 142' against silicon nitride (e.g., SiN, SiBCN, SiCN, SiOCN, etc.) forming the contact spacers 107.

Further, the 1^{st} dummy gate structure 115' of silicon nitride (e.g., SiN, SiBCN, SiCN, SiOCN, etc.) shown in FIGS. 19A-19E may be selectively removed through dry etching or wet etching using, an etchant, for example, chlorotrifluoromethane/oxygen (CHF₃/O₂) or hot phosphoric acid (H₃PO₄), not being limited thereto, against the 1^{st} sacrificial layers 111 of SiGe and the 1^{st} channel layers 112 of Si. Subsequently, the remaining EG layer 117 of silicon oxide (e.g., SiO, SiO₂, etc.) surrounding the 1^{st} channel layers 112 and the 1^{st} sacrificial layers 111 shown in FIGS. 19A-19E may be selectively removed through, for example, dry etching or wet etching against the 1^{st} channel layers 112 of Si to release the 1^{st} channel layers 112.

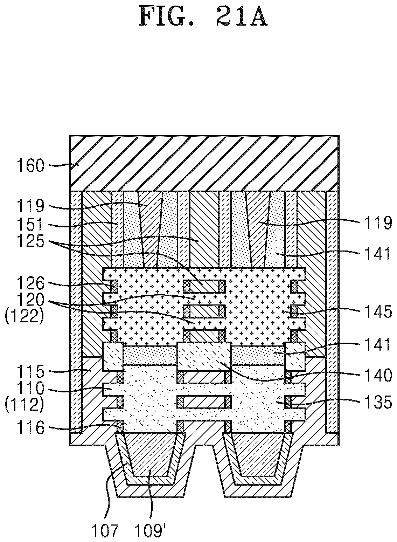

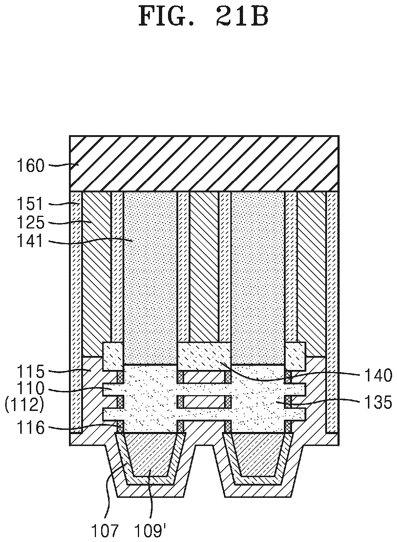

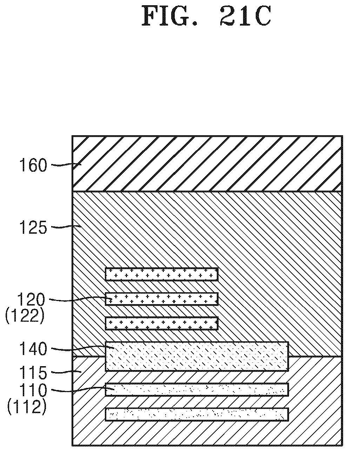

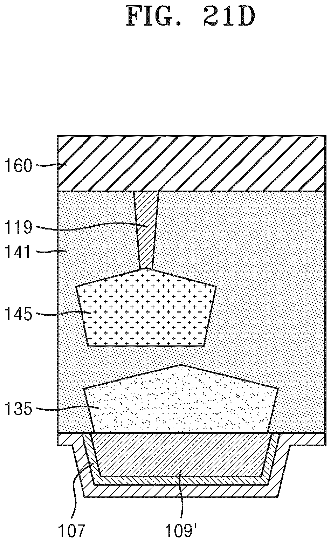

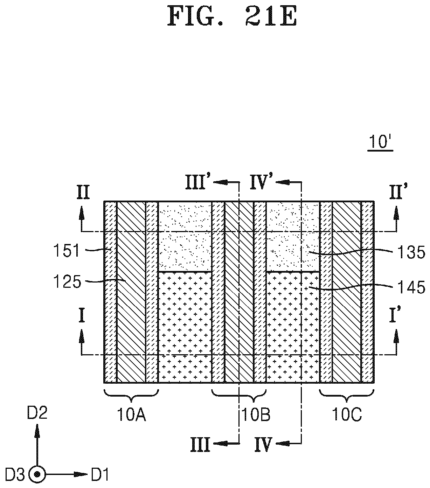

FIGS. 21A-21E illustrate the semiconductor device structure 10' in which a 1^{st} gate structure 115 may be formed to surround the 1^{st} channel layers 112, according to one or more embodiments.

Referring to FIG. 21A-21E, a 1^{st} gate structure 115 may be formed in a space provided by the removal of the initial backside isolation structure 142', the remaining EG layer 117, the 1^{st} dummy gate structure 115' and the 1^{st} sacrificial layers 111 shown in FIGS. 19A-19E in the previous step. The formation of the 1^{st} gate structure 115 may be performed through, for example, PVD, CVD, PECVD, ALD, PEALD, or a combination thereof, not being limited thereto.

Like the 2^{nd} gate structure 125, the 1^{st} gate structure 115 may also include a gate dielectric layer, a work-function metal layer and a gate electrode which are formed of the same or similar materials included in the 2^{nd} gate structure 125. Thus, duplicate descriptions thereof are omitted herein. However, when the 1^{st} gate structure 115 is to form an n-type transistor while the 2^{nd} gate structure 125 is to form a p-type transistor, the work-function metal layer of 1^{st} gate structure 115 may be formed of TiN, for example, while the work-function metal layer of the 2^{nd} gate structure 125 is formed of Al or TiC, for example, not being limited thereto.

In the meantime, while the 2^{nd} gate structure 125 may be formed, as shown in FIGS. 16A-16E, by replacing the 2^{nd} sacrificial layers 121 of Si which are etched twice at the side surfaces thereof as described in reference to FIGS. 7A-7E and 12A-12E, the 1^{st} gate structure 115 may replace the 1^{st} sacrificial layers of SiGe which are etched once at the side surfaces thereof as described in reference to FIGS. 9A-9E. Thus, the 1^{st} gate structure 115 may have a greater length in the D1 direction than the 2^{nd} gate structure 125. For example, as shown in FIG. 1F, the 1^{st} gate structure 115 may have the 5^{th} length L13 which is greater than the 6^{th} length L23 of the 2^{nd} gate structure 125.

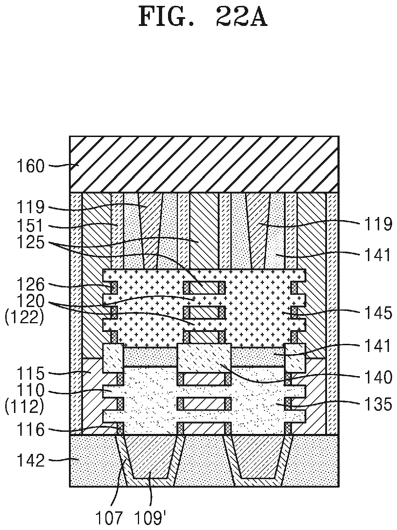

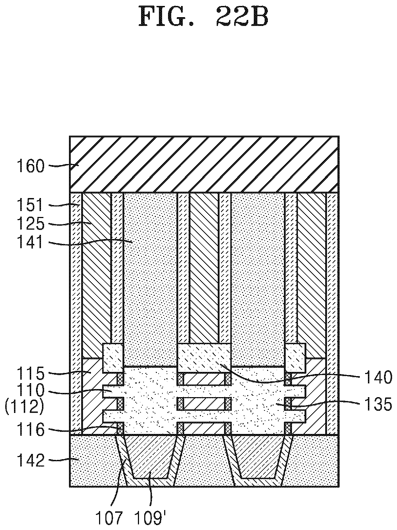

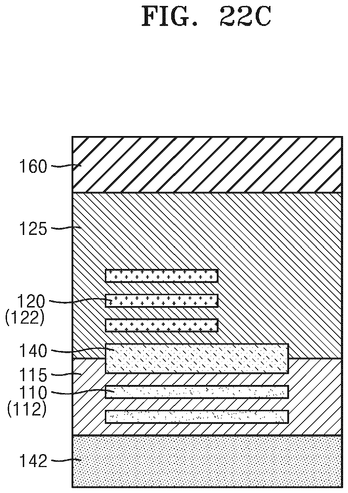

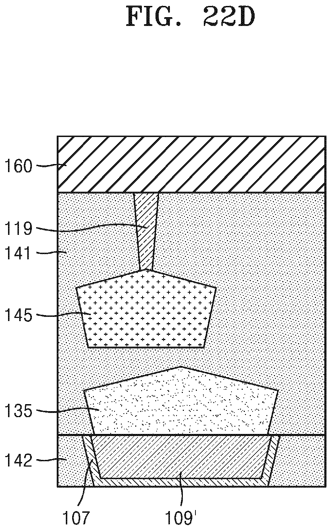

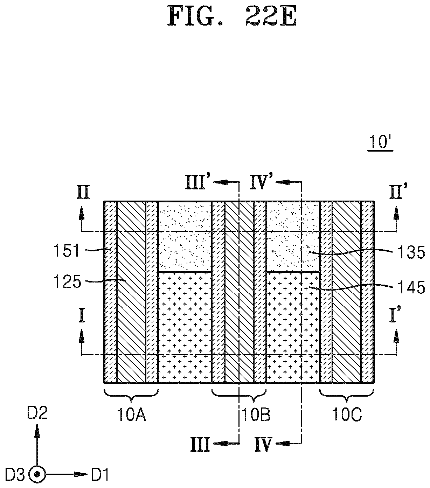

FIGS. 22A-22E illustrate the semiconductor device structure 10' in which the 1^{st} gate structure 115 formed in the previous step is partially etched back, and a backside isolation structure 142 may be formed at a back side of the semiconductor device structure 10', according to one or more embodiments.

Referring to FIGS. 22A-22E, the 1^{st} gate structure 115 formed to surround the 2^{nd} layer structure of the semiconductor device structure 10' including the placeholder structures 109' with the contact spacers 107 thereon may be removed from bottom to a level of bottom surfaces of the 1^{st} source/drain regions 135 or the lowermost 1^{st} inner spacers 116 through, for example, dry etching or wet etching, not being limited thereto.

Thus, while the 2^{nd} gate structure 125 may be formed in the frontside process as described in reference to FIGS. 16A-16E, the 1^{st} gate structure 115 may be formed in the backside process. Therefore, process variation that occurs in forming different gate structures at 1^{st} level and 2^{nd} level for a 3D-stacked semiconductor device may be easily controlled.

After formation of the 1^{st} gate structure 115 as above, the backside isolation structure 142 may be formed on the back side of the semiconductor device structure 10' to surround the placeholder structures 109' with the contact spacers 107 thereon such that a bottom surface of the backside isolation structure 142 is horizontally aligned with or coplanar with bottom surfaces of the contact spacers 107. The formation of the backside isolation structure 142 may be performed by depositing the same material forming the frontside isolation structure 141 (e.g., SiO, SiO₂, etc.) through, for example, PVD, CVD, PECVD, ALD, PEALD, or a combination thereof, not being limited thereto, followed by planarization (e.g., CMP).

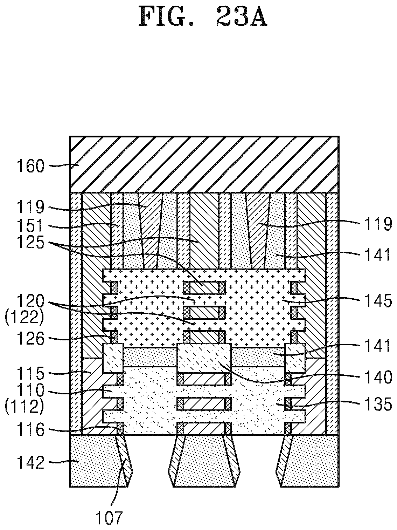

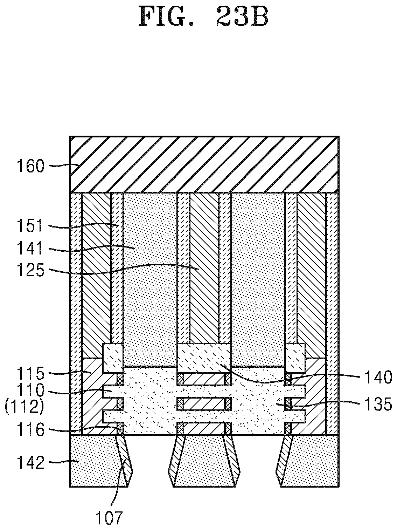

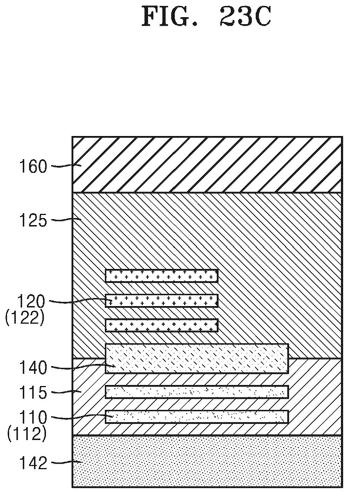

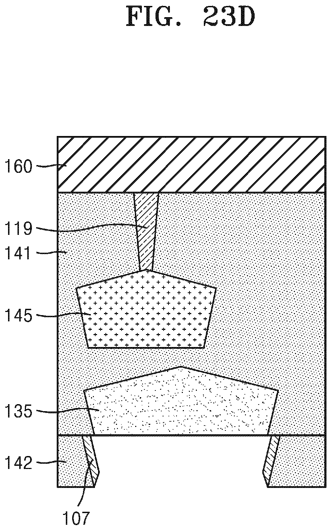

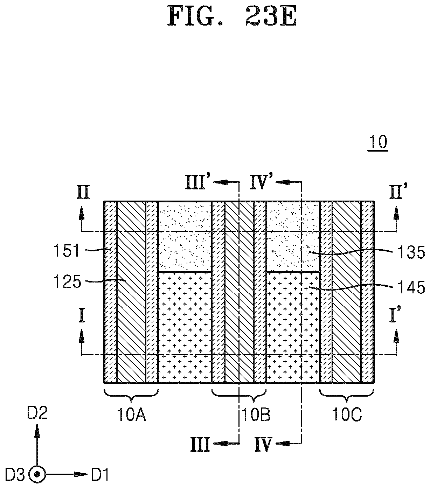

FIGS. 23A-23E illustrate the semiconductor device structure 10' in which the placeholder structures 109' shown in FIGS. 22A-22E are removed therefrom, according to one or more embodiments.

Referring to FIGS. 23A-23E, the bottom cap portion of each of the contact spacers 107 may be selectively removed against the backside isolation structure 142 to expose the placeholder structure 109' shown in FIGS. 22A-22E enclosed therein, and the placeholder structure 109' may be selectively removed against the contact spacer 107 and the 1^{st} source/drain region 135 formed on the placeholder structure 109'.

The selective removal of the bottom cap portion of the contact spacer 107 and the placeholder structure 109' may be performed by dry etching or wet etching using an etchant such as chlorotrifluoromethane/oxygen (CHF₃/O₂), hot phosphoric acid (H₃PO₄), a mixture of nitric acid (HNO₃) and hydrofluoric acid (HF), chlorine/oxygen (Cl₂/O₂), a mixture of hydrofluoric acid (HF) and ammonium fluoride (NH₄F), not being limited thereto.

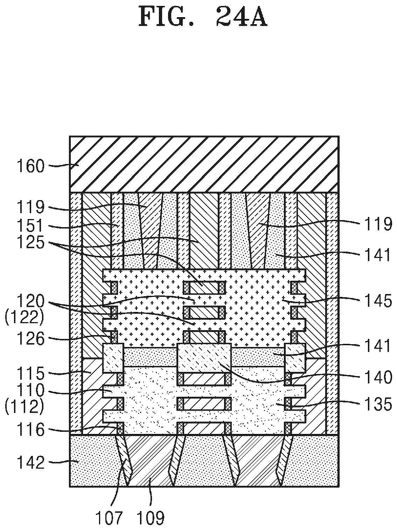

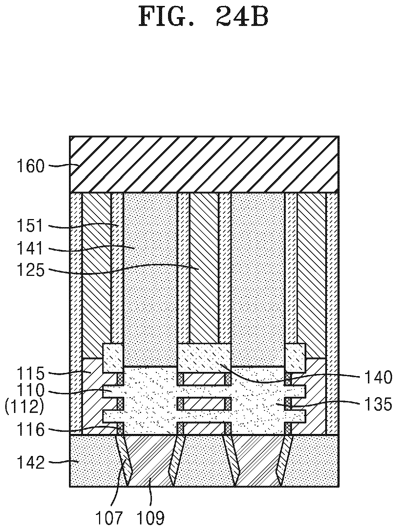

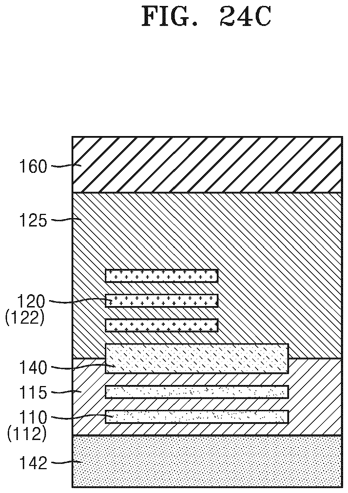

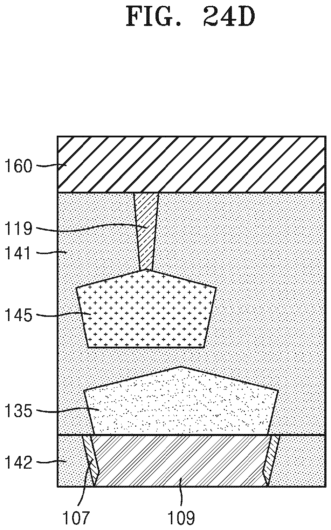

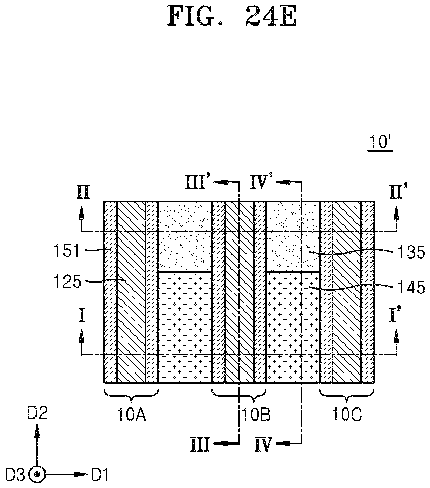

FIGS. 24A-24E illustrate the semiconductor device structure 10' in which backside contact structures 109 are formed in spaces provided by the removal of the placeholder structures 109' shown in FIGS. 22A-23E, respectively, according to one or more embodiments.

Referring to FIGS. 24A-24E, a backside contact structure 109 may be formed in a space provided by the removal of each of the placeholder structures 109' shown in FIGS. 22A-23E in a self-aligning manner due to the contact spacer 107. For example, a metal or metal compound such as Cu, W, Al, Ru, Mo, Co, and/or a combination thereof may be deposited along an inner side surface of the contact spacer 107 to fill in the space reserved by the placeholder structure 109' and contact a bottom surface of the 1^{st} source/drain region 135 thereon. Thus, possible misalignment between the backside contact structure 109 and the 1^{st} source/drain region 135 may be avoided.

The backside contact structure 109 may connect the 1^{st} source/drain region 135 to a voltage source or another circuit element through one or more metal lines formed below the backside contact structure 109. Thus, the backside contact structure 109 and these metal lines form a BSPDN structure for a 3D-stacked semiconductor device.

Thus, the semiconductor device structure 10' obtained in this step may take the same or similar structure as the 3D-stacked semiconductor device 10 shown in FIGS. 1A-1E. For example, in the semiconductor device structure 10', the 1^{st} channel layers 112 for a p-type transistor may be formed of Si while the 2^{nd} channel layers 122 for an n-type transistor may be formed of SiGe to take advantage of a higher hole mobility for current flow in the p-type transistor. Accordingly, the 1^{st} channel layers 112 may have a greater length than the 2^{nd} channel layers 122 of SiGe in the D1 direction, and the 1^{st} source/drain regions 135 may have a smaller length than the 2^{nd} source/drain regions 145 in the same D1 direction. Further, the 1^{st} gate structure 115 may have a greater length than the 2^{nd} gate structure 125 while the 1^{st} gate structure 115 and 2^{nd} gate structure 125 may be formed of different work-function metal layers.

Moreover, when the 1^{st} gate structure 115 and the 2^{nd} gate structure 125 are formed at the backside process and the frontside process, respectively, a risk of process variation may be reduced. Further, the formation of the contact spacers 107 may enable self-aligned formation of the backside contact structures 109 which may reduce misalignment between the backside contact structures 109 and the bottom surfaces of the 1^{st} source/drain regions 135 at the 1^{st} level, respectively.

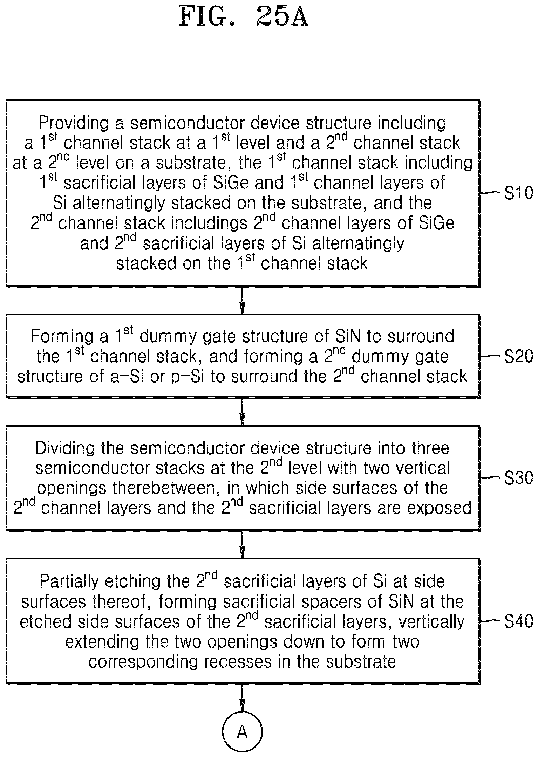

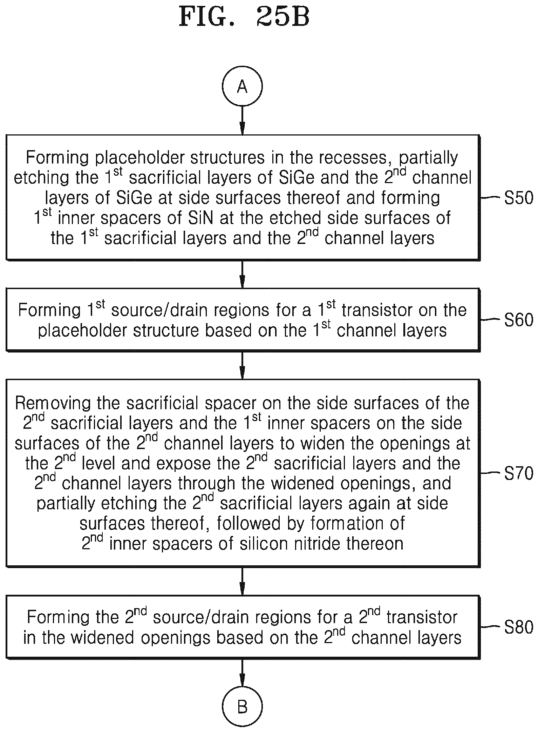

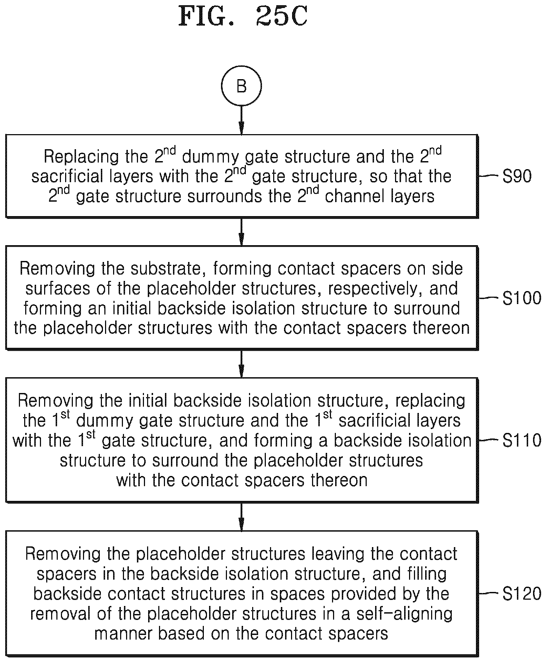

FIGS. 25A-25C illustrate a flowchart of manufacturing a 3D-stacked semiconductor device in which a channel structure, a source/drain region, and a gate structure of a transistor at a 1^{st} level are different from those of a transistor at a 2^{nd} level in dimension and material in reference to FIGS. 2A-2E to 24A-24E, according to one or more embodiments.

In step S10 (FIGS. 2A-2E), a semiconductor device structure 10' including a 1^{st} channel stack 110' at a 1^{st} level and a 2^{nd} channel stack 120' at a 2^{nd} level may be provided on a substrate 101, wherein the 1^{st} channel stack 110' includes 1^{st} sacrificial layers 111 of silicon germanium (SiGe) and 1^{st} channel layers 112 of silicon (Si) alternatingly stacked on the substrate 101, and the 2^{nd} channel stack 120' includes 2^{nd} channel layers 122 of SiGe (not Si) and 2^{nd} sacrificial layers 121 of Si (not SiGe) alternatingly stacked on the 1^{st} channel stack 110'.

The 1^{st} sacrificial layers 111 and the 1^{st} channel layers 112 of the 1^{st} channel stack 110' and the 2^{nd} sacrificial layers 121 and the 2^{nd} channel layers 122 the of 2^{nd} channel stack 120' may be epitaxially grown from the substrate 101 one by one in an alternating manner until a desired number of layers are obtained.

In step S20 (FIGS. 3A-3E and 4A-4E), a 1^{st} dummy gate structure 115' of silicon nitride may be formed to surround the 1^{st} channel stack 110', and a 2^{nd} dummy gate structure 125' of amorphous silicon (a-Si) or polycrystalline (p-Si) may be formed to surround the 2^{nd} channel stack 120'.

In step S30, (FIGS. 5A-5E and 6A-6E) the semiconductor device structure 10' with the 1^{st} dummy gate structure 115' and the 2^{nd} dummy gate structure 125' thereon may be divided into three semiconductor stacks 10A, 10B and 10C at the 2^{nd} level with two vertical openings therebetween, in which side surfaces of the 2^{nd} channel layers 122 and the 2^{nd} sacrificial layers 121 are exposed.

In step S40 (FIGS. 7A-7E and 8A-8E), the 2^{nd} sacrificial layers 121 of Si may be partially etched at side surfaces thereof and sacrificial spacers 126' of silicon nitride may be formed on the etched side surfaces of the 2^{nd} sacrificial layers 121', and the two openings O1 and O2 may be vertically extended down to form two corresponding recesses R1 and R2 in the substrate 101 and expose side surfaces of the 1^{st} sacrificial layers 111 and the 1^{st} channel layers 112 in the two openings O1 and O2.

Here, when the 2^{nd} sacrificial layers 121 of Si are partially etched at the side surfaces thereof, the 2^{nd} sacrificial layers 121 may have a smaller length in the channel-length direction than the 1^{st} sacrificial layers 111 of SiGe which are not partially etched at the side surfaces thereof at this time.

In step S50 (FIGS. 9A-9E), a placeholder structure 109' may be formed in each of the recesses R1 and R2 in the substrate 101, and the 1^{st} sacrificial layers 111 of SiGe and the 2^{nd} channel layers 122 of SiGe may be partially etched at side surfaces thereof and 1^{st} inner spacers 116 of silicon nitride may be formed on the etched side surfaces of the 1^{st} sacrificial layers 111 and the 2^{nd} channel layers 122.

The placeholder structures 109' may be formed in the substrate 101 to reserve spaces of backside contact structures 109 to be formed in a later step. The backside contact structure 109 may connect 1^{st} source/drain regions to be formed on the backside contact structure in a next step to one or more voltage sources or another circuit element.

In step S60 (FIGS. 10A-10E), 1^{st} source/drain regions 135 for a 1^{st} transistor may be formed on the placeholder structure 109' based on the 1^{st} channel layers 112.

The 1^{st} source/drain regions 135 may be epitaxially grown from the 1^{st} channel layers 112 of Si while the 1^{st} inner spacers 116 cover the 1^{st} sacrificial layers 111 of SiGe and the 2^{nd} channel layers 122 SiGe, and the sacrificial spacers 126' cover the 2^{nd} sacrificial layers 121 of Si. At this time, the 1^{st} source/drain region 135 of Si may be doped with impurities such as phosphorus (P), arsenic (As), antimony (Sb), etc. so that the 1^{st} transistor to be formed based on the 1^{st} channel layers 112 and the 1^{st} source/drain regions 135 at the 1^{st} level will be of an n-type.

In step S70 (FIGS. 11A-11E and 12A-12E), the sacrificial spacer 126' on the side surfaces of the 2^{nd} sacrificial layers 121 and the 1^{st} inner spacers 116 on the side surfaces of the 2^{nd} channel layers 122 may be removed together to widen the openings O1 and O2 at the 2^{nd} level and expose the 2^{nd} sacrificial layers 121 and the 2^{nd} channel layers 122 through the widened openings O1 and O2, and the 2^{nd} sacrificial layers 121 may be partially etched again at side surfaces thereof, followed by formation of 2^{nd} inner spacers 126 of silicon nitride thereon.

Here, the 2^{nd} sacrificial layers 121 are partially etched again in addition to the partial etching in step S40, and thus, the 2^{nd} sacrificial layers 121 may have a smaller length in the channel-length direction than the 1^{st} sacrificial layers 111 which are partially etched once at the side surfaces thereof in step S50.

In step S80 (FIGS. 13A-13E), the 2^{nd} source/drain regions 145 for a 2^{nd} transistor may be formed in the widened openings O1 and O2 based on the 2^{nd} channel layers 121.

The 2^{nd} source/drain regions 145 may be epitaxially grown from the 2^{nd} channel layers 122 of SiGe while the 2^{nd} sacrificial layers 121 of Si are covered by the 2^{nd} inner spacers 126. At this time, the 2^{nd} source/drain regions 145 may also be doped with impurities such as boron (b), gallium (Ga), indium (In), etc. so that the 2^{nd} transistor to be formed based on the 2^{nd} channel layers 122 and the 2^{nd} source/drain regions 145 at the 2^{nd} level will be of p-type.

When the 2^{nd} source/drain regions 145 are formed in the widened opening O1 and O2, the 2^{nd} source/drain regions 145 may have a greater length than the 1^{st} source/drain regions 135, respectively.

In step S90 (FIGS. 14A-14E to 17A-17E), the 2^{nd} dummy gate structure 125' and the 2^{nd} sacrificial layers 121 may be replaced by the 2^{nd} gate structure 125, and thus, the 2^{nd} channel layers 122 may now be surrounded by the 2^{nd} gate structure 125 instead of the 2^{nd} dummy gate structure 125'.

In step S100 (FIGS. 18A-18E and 19A-19E), the substrate 101 may be removed, contact spacers 107 may be formed on side surfaces of the placeholder structures 109', respectively, and an initial backside isolation structure 142' may be formed to surround the placeholder structures 109' with the contact spacers 107 thereon.

In step S110 (FIGS. 20A-20E to 22A-22E), the initial backside isolation structure 142' may be removed and the 1^{st} dummy gate structure 115' and the 1^{st} sacrificial layers 111 may be replaced by the 1^{st} gate structure 115, and then, a backside isolation structure 142 may be formed to surround the placeholder structures 109' with the contact spacers 107 thereon.

Thus, the 1^{st} channel layers 112 may now be surrounded by the 1^{st} gate structure 115. Here, the 1^{st} gate structure 115 may have a greater length than the 2^{nd} gate structure 125 because the 2^{nd} gate structure 125 may have replaced the 2^{nd} sacrificial layers 121 which are partially etched twice while the 1^{st} sacrificial layers 111 are partially etched once as described above in reference to step S70.

In step S120 (FIGS. 23A-23E and 24A-24E), the placeholder structures 109' may be removed leaving the contact spacers 107 in the backside isolation structure 142, and backside contact structures 109 may fill in spaces provided by the removal of the placeholder structures 109' in a self-aligning manner based on the contact spacers 107.

Through the above steps, a 3D-stacked semiconductor device 10 may be manufactured such that a channel structure 110 and 120, source/drain regions 135 and 145 and a gate structure 115 and 125 of a 1^{st} transistor 10L at a 1^{st} level are different from the same of a 2^{nd} transistor 10U at a 2^{nd} level in material and dimension.

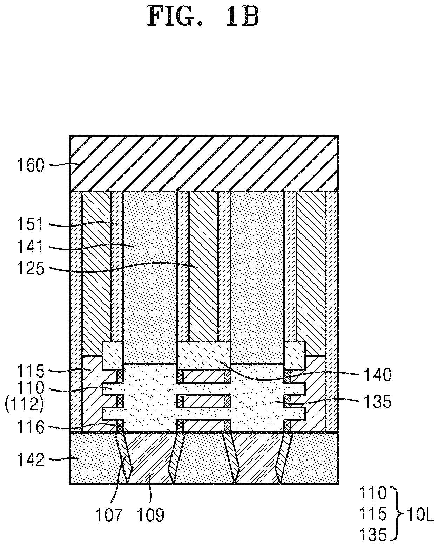

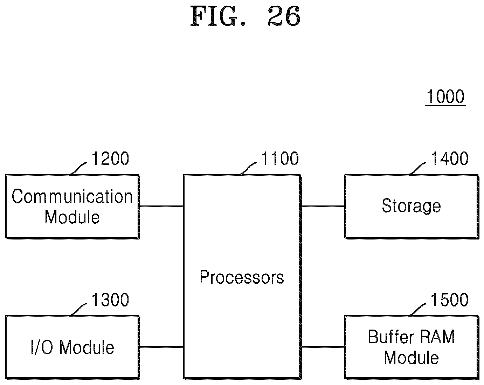

FIG. 26 is a schematic block diagram illustrating an electronic device including the 3D-stacked semiconductor device 10 shown in FIG. 1 or the 3D-stacked semiconductor device manufactured as described above in reference to FIGS. 2A-2E to FIGS. 25A-25E, according to one or more embodiments.

Referring to FIG. 26, an electronic device 1000 may include at least one processor 1100, a communication module 1200, an input/output module 1300, a storage 1400, and a buffer random access memory (RAM) module 1500. The electronic device 1000 may be a mobile device such as a smartphone or a tablet computer, not being limited thereto, according to embodiments.

The processor 1100 may include a central processing unit (CPU), a graphic processing unit (GPU) and/or any other processors that control operations of the electronic device 1000. The communication module 1200 may be implemented to perform wireless or wire communications with an external device. The input/output module 1300 may include at least one of a touch sensor, a touch panel a key board, a mouse, a proximate sensor, a microphone, etc. to receive an input, and at least one of a display, a speaker, etc. to generate an output signal processed by the processor 1100. The storage 1400 may be implemented to store user data input through the input/output module 1300, the output signal, etc. The storage 1400 may be an embedded multimedia card (eMMC), a solid state drive (SSD), a universal flash storage (UFS) device, etc.

The buffer RAM module 1500 may temporarily store data used for processing operations of the electronic device 1000. For example, the buffer RAM 1500 may include a volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

Although not shown in FIG. 26, the electronic device 1000 may further include at least one sensor such as an image sensor.

At least one component in the electronic device 1000 may be formed based on the 3D-stacked semiconductor devices 10 shown in FIG. 1 or the 3D-stacked semiconductor device manufactured as described above in reference to FIGS. 2A-2E to FIGS. 25A-25E, according to one or more embodiments.

## Claims

1. A semiconductor device (10) comprising:
1^{st} source/drain regions (135) connected through a 1^{st} channel structure (110) which is controlled by a 1^{st} gate structure (115); and
2^{nd} source/drain regions (145), respectively above the 1^{st} source/drain regions (135), connected through a 2^{nd} channel structure (120) which is controlled by a 2^{nd} gate structure (125),
wherein at least one of:
a) the 1^{st} channel structure (110) and the 2^{nd} channel structure (120) comprise different materials; and
b) in a 1^{st} direction in which the 1^{st} source/drain regions (135) are connected and the 2^{nd} source/drain regions (145) are connected: a length (L11) of the 1^{st} channel structure (110) is different from a length (L21) of the 2^{nd} channel structure (120), a length (L13) of the 1^{st} gate structure (115) is different from a length (L23) of the 2^{nd} gate structure (125), and/or a length (L12) of the 1^{st} source/drain regions (135) is different from a length (L22) of the 2^{nd} source/drain regions (145).

2. The semiconductor device (10) of claim 1, wherein the 1^{st} channel structure (110) comprises silicon germanium, SiGe, and the 2^{nd} channel structure (120) comprises silicon, Si.

3. The semiconductor device (10) of claim 1 or 2, wherein the length (L11) of the 1^{st} channel structure (110) is greater than the length (L21) of the 2^{nd} channel structure (120).

4. The semiconductor device (10) of any one of claims 1 to 3, wherein the length (L12) of the 1^{st} source/drain regions (135) is smaller than the length (L22) of the 2^{nd} source/drain regions (145).

5. The semiconductor device (10) of any one of claims 1 to 4, wherein the length (L13) of the 1^{st} gate structure (115) is greater than the length (L23) the 2^{nd} gate structure (125).

6. The semiconductor device (10) of any one of claims 1 to 5, wherein a width of the 1^{st} channel structure (110) is different from a width of the 2^{nd} channel structure (120) in a 2^{nd} direction which intersects the 1^{st} direction.

7. The semiconductor device (10) of claim 6, wherein the width of the 1^{st} channel structure (110) is greater than the width of the 2^{nd} channel structure (120).

8. The semiconductor device (10) of any one of claims 1 to 7, wherein a width of the 1^{st} source/drain regions (135) is greater than a width of the 2^{nd} source/drain regions (145) in a 2^{nd} direction which intersects the 1^{st} direction.

9. A method of manufacturing a semiconductor device (10), the method comprising:
forming (S10) a 1^{st} channel stack (110') at a 1^{st} level above a substrate (101), and forming a 2^{nd} channel stack (120') at a 2^{nd} level above the 1^{st} level, wherein the 1^{st} and 2^{nd} channel stacks (120') comprise different material compositions, respectively;
forming (S20) a 1^{st} dummy gate structure (115') and a 2^{nd} dummy gate structure to surround the 1^{st} channel stack (110') and the 2^{nd} channel stack (120'), respectively, wherein the 1^{st} and 2^{nd} dummy gate structures comprise different materials, respectively;
forming (S60) 1^{st} source/drain regions (135) at the 1^{st} level based on the 1^{st} channel stack (110');
forming (S80) 2^{nd} source/drain regions at the 2^{nd} level based on the 2^{nd} channel stack (120');
replacing (S90) the 2^{nd} dummy gate structure with a 2^{nd} gate structure (125);
replacing (S100) the substrate (101) with a backside isolation structure (142); and
replacing (S110) the 1^{st} dummy gate structure (115') with a 1^{st} gate structure (115).

10. The method of claim 9,
wherein the 1^{st} channel stack (110') is formed by alternatingly stacking 1^{st} sacrificial layers (111) of silicon germanium, SiGe, and 1^{st} channel layers (112) of silicon, Si, and
wherein the 2^{nd} channel stack (120') is formed by alternatingly stacking 2^{nd} channel layers (122) of SiGe and 2^{nd} sacrificial layers (121) of Si.

11. The method of claim 10, wherein the forming the 1^{st} source/drain regions (135) and the forming 2^{nd} source/drain regions (145) comprises:
forming sacrificial spacers (126) at side surfaces of the 2^{nd} sacrificial layers (121);
forming 1^{st} inner spacers (116) at side surfaces of the 1^{st} sacrificial layers (111) and the 2^{nd} channel layers (122);
epitaxially growing the 1^{st} source/drain regions (135) from the 1^{st} channel layers (112);
removing the sacrificial spacers (126) on the side surfaces of the 2^{nd} sacrificial layers (121), and removing the 1^{st} inner spacers (116) on the side surfaces of the 2^{nd} channel layers (122);
forming 2^{nd} inner spacers on side surfaces of the 2^{nd} sacrificial layers (121) from which the sacrificial spacers (126) are removed; and
epitaxially growing the 2^{nd} source/drain regions (145) from the 2^{nd} channel layers (122).

12. The method of any one of claims 9 to 11, wherein the replacing the 1^{st} dummy gate structure (115') with the 1^{st} gate structure performs after the replacing the substrate (101) with the backside isolation structure (142).

13. The method of any one of claims 9 to 12, further comprising:
forming a placeholder structure (109') in the substrate (101) prior to the forming the 1^{st} source/drain regions (135);
forming a contact spacer (107) on a side surface of the placeholder structure (109') in a process of the replacing the substrate (101) with the backside isolation structure (142); and
replacing the placeholder structure (109') with a backside contact structure (109) in a self-aligned manner using the contact spacer (107).
